# EUROPEAN PATENT SPECIFICATION

(11) **EP 0 636 939 B1**
(45) Date of publication and mention of the grant of the patent: **03.03.1999**
(21) Application number: 94305583.0
(22) Date of filing: 28.07.1994
(51) Int. Cl.: G03F 7/031, G03F 7/029

(54) **Photoinitiator compositions and photosensitive materials using the same**
Photoinitiatoren-Zusammensetzungen und photoempfindliche Materialien, die sie enthalten
Compositions de photoinitiateurs et matériaux photosensibles les contenant

(30) Priority: 28.07.1993 JP 185983/93; 24.08.1993 JP 209275/93; 28.09.1993 JP 241358/93; 08.02.1994 JP 14132/94; 10.02.1994 JP 16506/94; 15.02.1994 JP 17951/94
(43) Date of publication of application: 01.02.1995
(73) Proprietor: Hitachi Chemical Company, Ltd., Tokyo 163-0449 (JP)
(72) Inventor: Kaji, Makoto, Hitachi-shi (JP); Kojima, Yasunori, Hitachi-shi (JP); Katogi, Shigeki, Hitachi-shi (JP); Nunomura, Masataka, Hitachi-shi (JP)
(74) Representative: Marshall, Monica Anne

(56) References cited:
- EP-A- 0 304 136
- EP-A- 0 475 086
- EP-A- 0 566 353
- DATABASE WPI Section Ch, Week 9309, Derwent Publications Ltd., London, GB; Class A26, AN 93-071772 & JP-A-5 019 475 (HITACHI CHEM CO LTD) 29 January 1993

## Description

### BACKGROUND OF THE INVENTION

This invention relates to an N-aryl-α-amino acid, a photoinitiator composition using an N-aryl-α-amino acid and a 3-substituted coumarin and/or an azabenzalcyclohexanone, a photoinitiator composition using an N-aryl-α-amino acid, a 3-substituted coumarin and a titanocene, a photosensitive composition using one member selected from the group consisting of these photoinitiator compositions, a photosensitive material using one member selected from the group consisting of these photoinitiator compositions and a process for forming patterns using the photosensitive material.

Photosensitive compositions are widely used for forming letterpresses, relief images, photoresists, and the like generally using ultraviolet (UV) light as a light source, and are desired to have a higher sensitivity. Particularly, when photosensitive compositions are used for scanning light exposure by means of laser beams, they are required not only to be highly sensitive but also to have sufficiently high sensitivity to visible light (458, 488, 514.5 nm) which is an output wavelength of an argon laser. Further, in the case of photosensitive polyimide for thick films usable in semiconductors, it is required to have sufficient sensitivity to a g-line stepper using monochromic light (light of 435 nm), a contact exposing equipment using the whole wavelengths of a mercury lamp, and a mirror projection type exposing equipment, and to have good photosensitive wavelength properties.

In order to enhance the sensitivity, various studies have been done on photoinitiators. As the photoinitiators, there have been known benzoine and derivatives thereof, substituted or non-substituted polynuclear quinones, etc. But substances having excellent sensitivity meeting the above-mentioned objects have not been known yet.

On the other hand, polyimides or precursors thereof having photo-patterning properties by themselves are called as "photosensitive polyimides", which are used as a surface protective film for semiconductors. In order to impart photosensitivity to polyimides, various methods have been known. For example, Japanese Patent Examined Publication (JP-B) No. 55-41422 proposes a method for esterifying a poly(amic acid) with hydroxy acrylate. Japanese Patent Unexamined Publication (JP-A) Nos. 57-170929 and 54-145794 propose to introduce a photosensitive group by means of a salt bond by mixing poly(amic acid) with amino acrylate. In the case of the former (JP-B), the photo-patterning properties are relatively good, but since it is difficult to obtain a high polymer, removal of photosensitive groups becomes easily incomplete, resulting in showing a defect of poor film properties. On the other hand, in the latter case (two JP-A's), it is easy to obtain a high polymer and good film properties due to easy volatility, but photo-patterning properties are not sufficient. Particularly, in the case of photosensitive polyimides for thick films having a film thickness of 5 µm or more after cured, there is a problem in that no good patterning properties is obtained when exposed to light using an i-line stepper (light of 365 nm), a g-line stepper (light of 435 nm), a mirror projection type exposing equipment using whole wavelengths of a mercury lamp.

EP-A-0475086 discloses photosensitive polymer compositions comprising (a) a polymer obtained by reacting a poly(amic acid) with one or more amino compounds having at least one hydroxyl group and an isocyanate compound, and (b) one or more photosensitizers, photoinitiators or photocrosslinkers.

JP-A-5019475 discloses photoresist compositions comprising a coumarin compound and an N-aryl-α-amino acid wherein the aryl group is substituted by at least one electron attracting CN, NO₂, acyl

EP-A-0566353, which falls partly under Article 54(2) EPC and partly under Article 54(3) EPC, discloses photopolymerizable compositions comprising a three-component photosensitive photopolymerization initiator composition.

### SUMMARY OF THE INVENTION

It is an object of the present invention to provide a photoinitiator composition used for a photosensitive composition and a photosensitive material which have an excellent photosensitive property, the photosensitive composition, the photosensitive material, a process for forming patterns using the photosensitive material, namely, to provide an N-aryl-α-amino acid effective as a photoinitiator, a photoinitiator composition using an N-aryl-α-amino acid and a 3-substituted coumarin and/or an azabenzalcyclohexanone, a photoinitiator composition using an N-aryl-α-amino acid, a 3-substituted coumarin and a titanocene, a photosensitive composition using one member selected from the group consisting of these photoinitiator compositions, a photosensitive material using one member selected from the group consisting of these photoinitiator compositions, and a process for forming patterns using such photosensitive material overcoming the above-mentioned problems of prior art.

According to the new compositions of the present invention, the above problem that no good patterning properties is obtained when exposed to light using an i-line stepper, a g-line stepper, a mirror projection type exposing equipment using whole wave-lengths of a mercury lamp can be solved.

The present invention provides an N-aryl-α-amino acid of the formula: 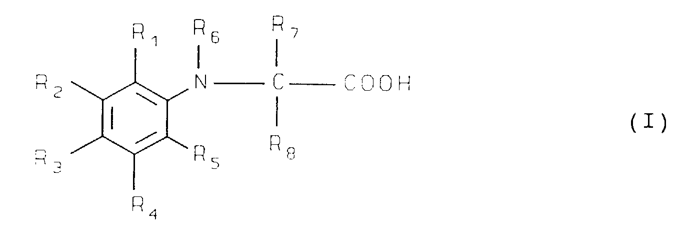 wherein R₁, R₂, R₃, R₄ and R₅ are independently a hydrogen atom, a halogen atom, an alkyl group having 1 to 4 carbon atoms, a cyano group, an alkoxycarbonyl group having 2 to 10 carbon atoms, CONH₂, or an alkylsulfonyl group having 1 to 4 carbon atoms and said alkyl moiety able to be substituted with a cyano group, and at least one of R₁ through R₅ is an alkylsulfonyl group having 1 to 4 carbon atoms; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms.

The present invention also provides a photoinitiator composition (A) comprising
an N-aryl-α-amino acid of the formula: 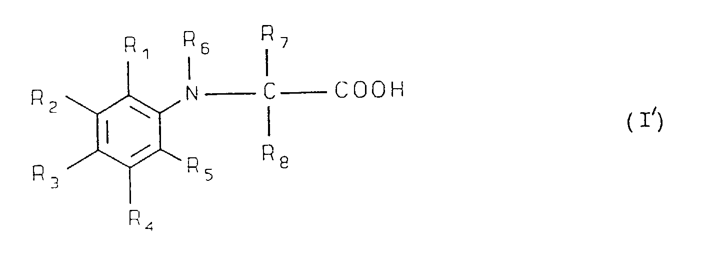 wherein R₁, R₂, R₃, R₄ and R₅ are independently a hydrogen atom, a halogen atom, an alkyl group having 1 to 4 carbon atoms, a cyano group, an alkoxycarbonyl group having 2 to 10 carbon atoms, CONH₂ or an alkylsulfonyl group having 1 to 4 carbon atoms and said alkyl moiety being able to be substituted with a cyano group, and at least one of R₁ through R₅ is an alkoxycarbonyl group having 2 to 10 carbon atoms, CONH₂, or an alkylsulfonyl group having 1 to 4 carbon atoms; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms, and
at least one member selected from the group consisting of a 3-substituted coumarin compound of the formula: 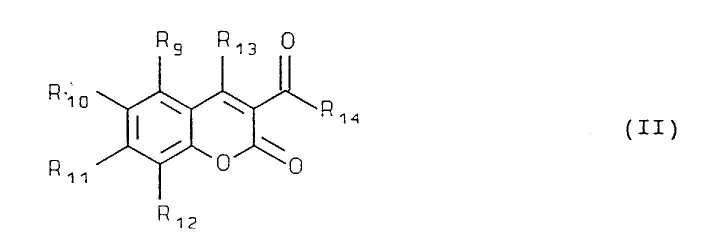 wherein R₉, R₁₀, R₁₁, R₁₂ and R₁₃ are independently a hydrogen atom, an amino group substituted with an alkyl group having 1 to 5 carbon atoms, an amino group substituted with two alkyl groups having 1 to 5 carbon atoms, an alkoxy group having 1 to 5 carbon atoms, an acyloxy group, an aryl group, a halogen atom, or a thioalkyl group having 1 to 5 carbon atoms; and R₁₄ is a non-substituted phenyl group, a biphenyl group, a naphthyl group, a thienyl group, a benzofuryl group, a furyl group, a pyridyl group, a coumarinyl group, an amino group, an amino group substituted with one or more alkyl groups having 1 to 5 carbon atoms, a cyano group, an alkoxy group having 1 to 5 carbon atoms, an alkyl group having 1 to 5 carbon atoms, a halogen atom, a haloalkyl group, a formyl group, an alkoxycarbonyl group having 1 to 5 carbon atoms, an acyloxy group having 1 to 5 carbon atoms, a phenyl group substituted with an acyloxy group having 1 to 5 carbon atoms, a cyano group, an alkoxy group or an acyl group having 1 to 5 carbon atoms, said biphenyl group, said naphthyl group, said thienyl group, said benzofuryl group, said furyl group, said pyridyl group or coumarinyl group being able to be substituted by an acyloxy group having 1 to 5 carbon atoms or an acyl group having 1 to 5 carbon atoms, and an azabenzalcyclohexanone compound of the formula: 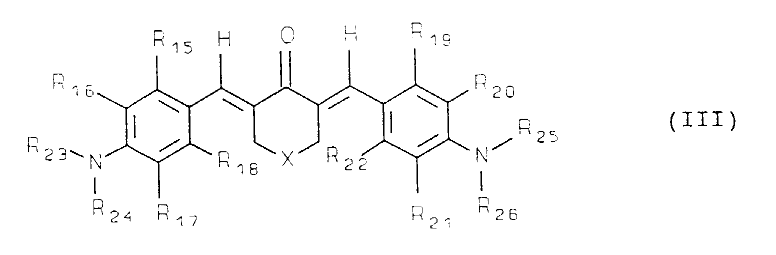 wherein R₁₅, R₁₆, R₁₇, R₁₈, R₁₉, R₂₀, R₂₁ and R₂₂ are independently a hydrogen atom, a chlorine atom, a bromine atom, an alkyl group having 1 to 12 carbon atoms, an aryl group or an alkoxy group having 1 to 12 carbon atoms; and R₂₃, R₂₄, R₂₅ and R₂₆ are independently an alkyl group having 1 to 6 carbon atoms; X is an imino group which may be substituted with an alkyl group having 1 to 12 carbon atoms, an aralkyl group having 7 to 20 carbon atoms, an aryl group, an acyl group having 2 to 12 carbon atoms, an arylcarbonyl group having 7 to 20 carbon atoms, an alkoxycarbonyl group having 2 to 12 carbon atoms, or an aryloxycarbonyl group having 7 to 20 carbon atoms.

The present invention further provides a photoinitiator composition (B) comprising
an N-aryl-α-amino acid of the formula: 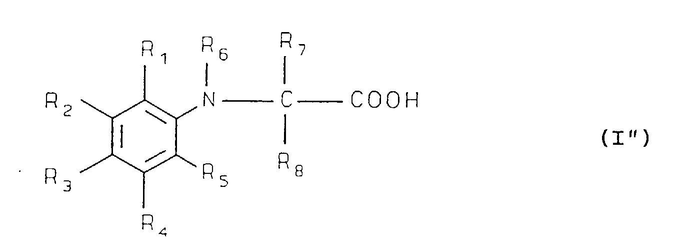 wherein R₁, R₂, R₃, R₄ and R₅ are independently a hydrogen atom, an alkyl group having 1 to 4 carbon atoms, a cyano group, an alkoxycarbonyl group having 2 to 10 carbon atoms, CONH₂, or an alkylsulfonyl group having 1 to 4 carbon atoms and said alkyl moiety being able to be substituted with a cyano group, with the proviso that R₁ through R₅ cannot all be hydrogen atoms at the same time; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms,
a 3-substituted coumarin compound of the formula (II), and
a titanocene compound of the formula: 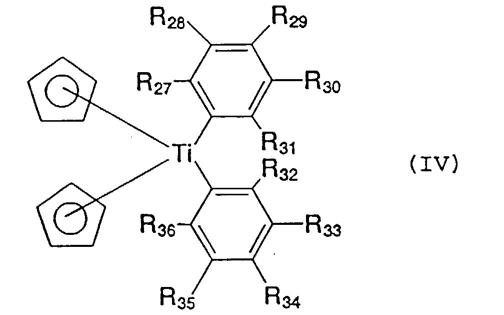 wherein R²⁷ through R³⁶ are independently a hydrogen atom, a halogen atom, an alkoxy group having 1 to 20 carbon atoms or a heterocyclic ring such as 1-pyrrolyl, 2-pyrrolyl, 3-pyrrolyl, imidazolyl, pyrazolyl, said heterocyclic ring being bound to a benzene ring directly or via an alkylene group and may be substituted with one or more alkyl groups, amino groups, alkylamino groups and alkoxy groups.

The present invention also provides a photosensitive composition comprising
an addition polymerizable compound having a boiling point of 100°C or higher under 1 atmosphere, and
a photoinitiator composition (A) or (B).

The present invention further provides a photosensitive material comprising
(a) a poly(amic acid),
(b) a compound having one or more carbon-carbon double bonds dimerizable or polymerizable by actinic radiation and one or more amino groups or a quaternary salt thereof, and
(c) a photoinitiator composition (A) or (B).

The present invention still further provides a process for forming a pattern using the photosensitive material mentioned above.

### DESCRIPTION OF THE PREFERRED EMBODIMENTS

The N-aryl-α-amino acid of the present invention is represented by the formula: 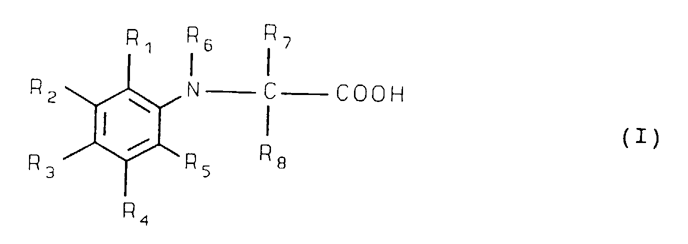 wherein R₁, R₂, R₃, R₄ and R₅ are independently a hydrogen atom, a halogen atom, an alkyl group having 1 to 4 carbon atoms, a cyano group, an alkyloxycarbonyl group having 2 to 10 carbon atoms, CONH₂ or an alkylsulfonyl group having 1 to 4 carbon atoms and said alkyl moiety able to be substituted with a cyano group, and at least one of R₁ through R₅ is an alkylsulfonyl group having 1 to 4 carbon atoms; R₆ is a hydrogen atom, an alkyl group having 1 to 12 carbon atoms, a cycloalkyl group preferably having 3 to 7 carbon atoms, a hydroxyalkyl group having 1 to 12 carbon atoms, an alkoxyalkyl group having 2 to 12 carbon atoms, or a substituted or non-substituted aryl group preferably having 6 to 10 carbon atoms such as phenyl, naphthyl; and R₇ and R₈ are independently a hydrogen atom or an alkyl group having 1 to 8 carbon atoms.

When the compound of the formula (I) is used in a photoinitiator composition, the limitation of "and at least one of R₁ through R₅ is an alkylsulfonyl group having 1 to 4 carbon atoms" is replaced by the alternative limitations in formulae (I') and (I") as hereinbefore defined.

The N-aryl-α-amino acid of the formula (I), or (I') or (I") can be produced, for example, by aromatic nucleophilic substitution of a corresponding substituted halobenzene with a glycine compound using an analogous process.

More concretely, the aromatic nucleophilic substitution can be carried out generally by reacting a substituted halobenzene and a glycine compound in about equimolar amounts in a polar aprotic solvent such as acetone, dimethylsulfoxide, N-methyl-pyrrolidone, N,N-dimethylacetamide, N,N-dimethylformamide, tetrahydrofuran, sulfolane, methyl ethyl ketone, ethylene carbonate, etc., in the presence of a basic compound at room temperature to about 100°C. As the basic compound, there can be used sodium carbonate, potassium carbonate, etc.

Examples of the compound of the formula (I), (I') or (I") are as follows:
N-(p-methylsulfonylphenyl)-N-methylglycine (Compound No. 1),
N-(p-methylsulfonylphenyl)-N-ethylglycine,
N-(p-methylsulfonylphenyl)-N-n-propylglycine,
N-(p-methylsulfonylphenyl)-N-n-butylglycine,
N-(p-cyanophenyl)glycine (Compound No.2) ((I"))
N-(p-cyanomethylsulfonylphenyl)-N-methylglycine,
N-(p-cyanomethylsulfonylphenyl)--N-ethylglycine,
N-(p-cyanomethylsulfonylphenyl)-N-n-propylglycine,
N-(p-cyanomethylsulfonylphenyl)-N-n-butylglycine,
N-(p-ethylsulfonylphenyl)-N-methylglycine,
N-(p-ethylsulfonylphenyl)-N-ethylglycine,
N-(p-ethylsulfonylphenyl)-N-n-propylglycine,
N-(p-ethylsulfonylphenyl)-N-n-butylglycine,
N-(p-2'-cyanoethylsulfonylphenyl)-N-methylglycine,
N-(p-2'-cyanoethylsulfonylphenyl)-N-ethylglycine,
N-(p-2'-cyanoethylsulfonylphenyl)-N-n-propylglycine,
N-(p-2'-cyanoethylsulfonylphenyl)-N-n-butylglycine,
N-(p-cyanophenyl)-N-methylglycine (Compound No. 3)((I")),
N-(p-cyanophenyl)-N-ethylglycine ((I")),
N-(p-cyanophenyl)-N-n-propylglycine ((I")),
N-(p-cyanophenyl)-N-n-butylglycine ((I")),
N-(p-n-propylsulfonylphenyl)-N-methylglycine,
N-(p-n-butylsulfonylphenyl)-N-methylglycine,
N-(p-carboxyamidophenyl)-N-methylglycine,
N-(p-carboxyamidophenyl)-N-ethylglycine,
N-(p-carboxyamidophenyl)-N-n-propylglycine,
N-(p-carboxyamidophenyl)-N-n-butylglycine,
N-(p-ethoxycarbonylphenyl)-N-methylglycine,
N-(p-ethoxycarbonylphenyl)-N-ethylglycine,
N-(p-ethoxycarbonylphenyl)-N-n-propylglycine,
N-(p-ethoxycarbonylphenyl)-N-n-butylglycine,
N-(p-methoxycarbonylphenyl)-N-methylglycine,
N-(p-methoxycarbonylphenyl)-N-ethylglycine,
N-(p-methoxycarbonylphenyl)-N-n-propylglycine,
N-(p-methoxycarbonylphenyl)-N-n-butylglycine, etc.

These compounds can be used singly or as a mixture thereof, when used as a photoinitiator.

These compounds are effective as a photowhich generates active radicals by the action of UV and visible light in combination of one or more suitable photosensitizers.

A photoinitiator composition (A) of the present invention comprises:
an N-aryl-α-amino acid of the formula (I') mentioned above, and
at least one member selected from the group consisting of a 3-substituted coumarin compound of the formula: 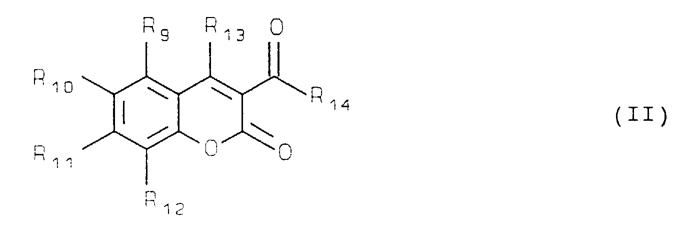 wherein R₉, R₁₀, R₁₁, R₁₂ and R₁₃ are independently a hydrogen atom, an amino group substituted with an alkyl group having 1 to 5 carbon atoms, an amino group substituted with two alkyl groups having 1 to 5 carbon atoms, an alkoxy group having 1 to 5 carbon atoms, an acyloxy group, an aryl group such as phenyl, naphthyl, a halogen atom, or a thioalkyl group having 1 to 5 carbon atoms; and R₁₄ is a non-substituted phenyl group, a biphenyl group, a naphthyl group, a thienyl group, a benzofuryl group, a furyl group, a pyridyl group, a coumarinyl group, an amino group, an amino group substituted with one or more alkyl groups having 1 to 5 carbon atoms, a cyano group, an alkoxy group having 1 to 5 carbon atoms, an alkyl group having 1 to 5 carbon atoms, a halogen atom, a haloalkyl group, a formyl group, an alkoxycarbonyl group having 1 to 5 carbon atoms, an acyloxy group having 1 to 5 carbon atoms, a phenyl group substituted with an acyloxy group having 1 to 5 carbon atoms, a cyano group, an alkoxy group, or an acyl group having 1 to 5 carbon atoms, said biphenyl group, said naphthyl group, said thienyl group, said benzofuryl group, said furyl group, said pyridyl group or said coumarinyl group being able to be substituted with an acyloxy group having 1 to 5 carbon atoms or an acyl group having 1 to 5 carbon atoms, and an azabenzalcyclohexanone compound of the formula: 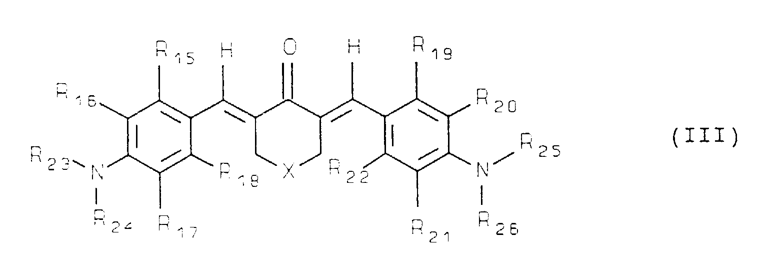 wherein R₁₅, R₁₆, R₁₇, R₁₈, R₁₉, R₂₀, R₂₁ and R₂₂ are independently a hydrogen atom, a chlorine atom, a bromine atom, an alkyl group having 1 to 12 carbon atoms, an aryl group such as phenyl, naphthyl, etc. or an alkoxy group having 1 to 12 carbon atoms; and R₂₃, R₂₄, R₂₅ and R₂₆ are independently an alkyl group having 1 to 6 carbon atoms; X is an imino group which may be substituted with an alkyl group having 1 to 12 carbon atoms, an aralkyl group having 7 to 20 carbon atoms such as benzyl, phenethyl, an aryl group such as phenyl, naphthyl, etc., an acyl group having 2 to 12 carbon atoms, an arylcarbonyl group having 7 to 20 carbon atoms, an alkoxycarbonyl group having 2 to 12 carbon atoms, or an aryloxycarbonyl group having 7 to 20 carbon atoms.

Examples of the 3-substituted coumarin compound of the formula (II) are as follows:
3-benzoylcoumarin,
3-benzoyl-7-methoxycoumarin,
3-benzoyl-5,7-dimethoxycoumarin,
3-(4'-cyanobenzoyl)-coumarin,
3-(4'-cyanobenzoyl)-7-methoxycoumarin,
3-(4'-cyanobenzoyl)-5,7-dimethoxycoumarin,
3-thienylcarbonylcoumarin,
7-methoxy-3-thienylcarbonyl-coumarin,
5,7-dimethoxy-3-thienylcarbonyl-coumarin,
7-diethylamino-3-thienylcarbonyl-coumarin,
7-dimethylamino-3-thienylcarbonyl-coumarin,
3-(4'-methoxybenzoyl)coumarin,
3-(4'-methoxybenzoyl)-7-methoxycoumarin,
3-(4'methoxybenzoyl)-5,7-dimethoxycoumarin,
3,3'-carbonylbis-(7-diethylaminocoumarin),
3,3'-carbonylbis-(7-methoxycoumarin),
3,3'-carbonylbis-(5,7-dimethoxycoumarin), etc.

These compounds can be used singly or as a mixture thereof.

Examples of the azabenzalcyclohexanone compound of the formula (III) are as follows:
2,6-bis(p-N,N-diethylaminobenzal)-4-methyl-4-azacyclohexanone,
2,6-bis(p-N,N-dimethylaminobenzal)-4-methyl-4-azacyclohexanone,
2,6-bis(p-N,N-diethylaminobenzal)-4-ethyl-4-azacyclohexanone,
2,6-bis(p-N,N-dimethylaminobenzal)-4-ethyl-4-azacyclohexanone,
2,6-bis(p-N,N-diethylaminobenzal)-4-n-propyl-4-azacyclohexanone,
2,6-bis(p-N,N-dimethylaminobenzal)-4-n-propyl-4-azacyclohexanone,
2,6-bis(p-N,N-diethylaminobenzal)-4-phenethyl-4-azacyclohexanone,
2,6-bis(p-N,N-dimethylaminobenzal)-4-benzyl-4-azacyclohexanone,
2,6-bis(p-N,N-dimethylaminobenzal)-4-acetyl-4-azacyclohexanone,
2,6-bis(p-N,N-dimethylaminobenzal)-4-benzoyl-4-azacyclohexanone, etc.

These compounds can be synthesized by the method shown in U.S. Patent No. 4,987,057.

These compounds can be used singly or as a mixture thereof.

The N-aryl-α-amino acid of the formula (I') and the 3-substituted coumarin compound of the formula (II) and/or the azabenzalcyclohexanone compound of the formula (III) may be used in various proportions, but the N-aryl-α-amino acid by the formula (I') is preferably used in a larger amount than that of the compound of the formula (II) and/or (III). Generally, in case of using either the compound of the formula (II) or (III), the compound of the formula (II) or (III) is used in an amount of 1 to 100 parts by weight per 100 parts by weight of the compound of the formula (I'), and in case of using both the compounds of the formulae (II) and (III), a total amount of the compounds of the formulae (II) and (III) is used in an amount of 1 to 100 parts by weight per 100 parts by weight of the compound of the formula (I').

Another photoinitiator composition (B) of the present invention comprises
an N-aryl-α-amino acid of the formula (I"),
a 3-substituted coumarin compound of the formula (II), and
a titanocene compound of the formula: 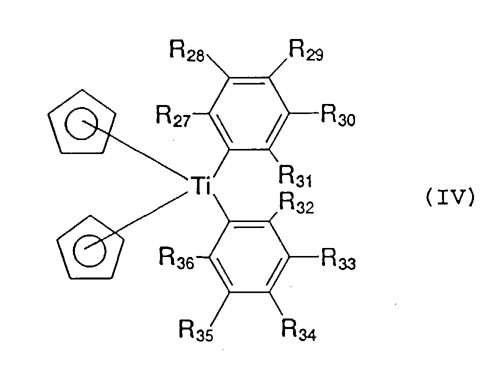 wherein R₂₇ through R₃₆ are independently a hydrogen atom, a halogen atom, an alkoxy group having 1 to 20 carbon atoms or a heterocyclic ring such as pyrrole, etc., said heterocyclic ring being bound to a benzene ring directly or via an alkylene group and may be substituted with one or more alkyl groups, amino groups, alkylamino groups and alkoxy groups.

Examples of the titanocene compound of the formula (IV) are as follows:
bis(cyclopentadienyl)-bis[2,6-difluoro-3-{2-(1H-pyrrol-1-yl)ethyl}phenyl] titanium,
bis(cyclopentadienyl)-bis[2,6-difluoro-3-{2-(1H-pyrrol-1-yl)propyl}phenyl] titanium,
bis(cyclopentadienyl)-bis[2,6-difluoro-3-{2-(1H-pyrrol-1-yl)methyl}phenyl] titanium,
bis(cyclopentadienyl)-bis[2,6-difluoro-3-(pyrrol-1-yl)phenyl] titanium,
bis(cyclopentadienyl)-bis[2,6-difluoro-3-(2,5-dimethylpyrrol-1-yl)phenyl] titanium,
bis(cyclopentadienyl)-bis[2,6-difluoro-3-(2,5-diethylpyrrol-1-yl)phenyl] titanium,
bis(cyclopentadienyl)-bis[2,6-difluoro-3-(2,5-diisopropylpyrrol-1-yl)phenyl] titanium,
bis(cyclopentadienyl)-bis[2,6-difluoro-3-(2,5-bisdimethylaminopyrrol-1-yl)phenyl] titanium,
bis(cyclopentadienyl)-bis[2,6-difluoro-3-(2,5-dimethyl-3-methoxypyrrol-1-yl)phenyl] titanium,
bis(cyclopentadienyl)-bis[2,6-difluoro-3-methoxyphenyl] titanium,
bis(cyclopentadienyl)-bis[2,6-difluoro-3-ethoxyphenyl] titanium,
bis(cyclopentadienyl)-bis[2,6-difluoro-3-isopropoxyphenyl] titanium,
bis(cyclopentadienyl)-bis[2,6-difluoro-3-n-propoxyphenyl] titanium, etc.

These titanocene compounds can be used singly or as a mixture thereof.

The compound of the formula (II) and the compound of the formula (IV) may be used in various proportions, but the compound of the formula (II) is preferably used in an amount of 1 to 100 parts by weight, and the compound of the formula (IV) is preferably used in an amount of 10 to 300 parts by weight, per 100 parts by weight of the compound of the formula (I").

The photosensitive composition of the present invention comprises
an addition polymerizable compound having a boiling point of 100°C or higher under 1 atmosphere, and
a photoinitiator composition (A) or (B).

The photosensitive composition may further contain, if necessary, one or more conventional photopolymerization initiators.

Examples of the photopolymerization initiator are as follows:
Michler's ketone,
benzoin methyl ether,
benzoin ethyl ether,
benzoin isopropyl ether,
2-t-butylanthraquinone,
2-ethylanthraquinone,
4,4'-bis(N,N-diethylamino)benzophenone,
acetophenone,
benzophenone,
thioxanthone,
2,2-dimethoxy-2-phenylacetophenone,
1-hydroxycyclohexylphenyl ketone,
2-methyl-[4-(methylthio)phenyl]-2-morpholino-1-propanone,
benzil,
diphenyl disulfide,
phenanthrenequinone,
2-isopropylthioxanthone,
riboflavine tetrabutyrate,
N-phenyldiethanolamine,
2-(O-ethoxycarbonyl)oxyimino-1,3-diphenylpropanedione,
1-phenyl-2-(O-ethoxycarbonyl)oxyiminopropan-1-one,
3,3',4,4'-tetra(t-butylperoxycarbonyl)-benzophenone, etc.

These photopolymerization initiators can be used singly or as a mixture thereof.

The photopolymerization initiators may be used in various proportions.

The addition polymerizable compound should have a boiling point of 100°C or higher under 1 atmosphere. When the addition polymerizable compound has a boiling point of lower than 100°C under 1 atmosphere, it evaporates at the time of removing a solvent in a system, for example, by drying or at the time of irradiation with actinic radiation, resulting in giving undesirable properties. Further, in order to obtain a uniform composition with a photoinitiator composition, it is preferable to use those soluble in conventionally used organic solvents.

As a solvent usable for the photosensitive composition, there can be used acetone, methyl ethyl ketone, diethyl ketone, toluene, chloroform, methanol, ethanol, 1-propanol, 2-propanol, 1-butanol, 2-butanol, t-butanol, ethylene glycol monomethyl ether, ethylene glycol monoethyl ether, xylene, tetrahydrofuran, dioxane, N,N-dimethylacetamide, N,N-dimethylformamide, N-methyl-2-pyrrolidone, γ-butyrolactone, dimethylsulfoxide, ethylene carbonate, propylene carbonate, sulfolane, etc. These solvents can be used singly or as a mixture thereof.

As the addition polymerizable compound having a boiling point of 100°C or higher under 1 atmosphere, there can preferably be used those obtained by condensing a polyhydric alcohol with an α,β-unsaturated carboxylic acid.

Examples of such compounds are as follows:
ethylene glycol di(meth)acrylate (di(meth)acrylate means "diacrylate" or "dimethacrylate", herein-after used in this manner),
triethylene glycol di(meth)acrylate,
tetraethylene glycol di(meth)acrylate,
trimethylolpropane di(meth)acrylate,
trimethylolpropane tri(meth)acrylate,
1,2-propylene glycol di(meth)acrylate,
di(1,2-propylene glycol) di(meth)acrylate,
tri(1,2-propylene glycol) di(meth)acrylate,
tetra(1,2-propylene glycol) di(meth)acrylate,
dimethylaminoethyl (meth)acrylate,
diethylaminoethyl (meth)acrylate,
dimethylaminopropyl (meth)acrylate,
diethylaminopropyl (meth)acrylate,
1,4-butanediol di(meth)acrylate,
1,6-hexanediol di(meth)acrylate,
pentaerythritol tri(meth)acrylate,
pentaerythritol tetra(meth)acrylate,
styrene,
divinylbenzene,
4-vinyltoluene,
4-vinylpyridine,
N-vinylpyrrolidone,
2-hydroxyethyl (meth)acrylate,
1,3-(meth)acryloyloxy-2-hydroxypropane,
methylenebisacrylamide,
N,N-dimethylacrylamide,
N-methylolacrylamide, etc.

These compounds can be used singly or as a mixture thereof.

The photoinitiator composition (A) or (B) is used in an amount of 0.01 to 30% by weight, preferably 0.05 to 10% by weight, based on the weight of the addition polymerizable compound having a boiling point of 100°C or higher under 1 atmosphere from the viewpoint of photosensitivity and film strength.

The photosensitive composition of the present invention may further contain, if necessary, one or more organic polymer having a high molecular weight of preferably 10,000 to 700,000.

Examples of such an organic polymer are as follows:

### (A) Copolyesters

Copolyesters obtained by reacting a polyhydric alcohol, for example, diethylene glycol, triethylene glycol, tetraethylene glycol, trimethylolpropane, neopentyl glycol, etc. with a polyvalent carboxylic acid, for example, terephthalic acid, isophthalic acid, sebacic acid, adipic acid, etc.

### (B) Vinyl polymers

Homopolymers or copolymers of vinyl monomers such as methacrylic acid, acrylic acid, alkyl esters of methacrylic acid or acrylic acid, for example, methyl (meth)acrylate, ethyl (meth)acrylate, butyl (meth)acrylate, 2-hydroxyethyl (meth)acrylate, phenyl (meth)acrylate, benzyl (meth)acrylate, 2-dimethylaminoethyl (meth)acrylate, 2-ethylhexyl (meth)acrylate, etc.

### (C) Polyformaldehydes

### (D) Polyurethanes

### (E) Polycarbonates

### (F) Polyamides

### (G) Poly(amic acid)s

Poly(amic acid)s can be prepared by addition polymerization of a tetracarboxylic dianhydride and a diamine compound.

Examples of the tetracarboxylic dianhydride are as follows:
pyromellitic dianhydride,
3,3',4,4'-benzophenonetetracarboxylic dianhydride,
3,3',4,4'-biphenyltetracarboxylic dianhydride,
1,2,5,6-naphthalenetetracarboxylic dianhydride,
2,3,6,7-naphthalenetetracarboxylic dianhydride,
2,3,5,6-pyridinetetracarboxylic dianhydride,
1,4,5,8-naphthalenetetracarboxylic dianhydride,
3,4,9,10-perylenetetracarboxylic dianhydride,
4,4'-sulfonyldiphthalic dianhydride,
m-terphenyl-3,3'',4,4''-tetracarboxylic dianhydride,
p-terphenyl-3,3'',4,4''-tetracarboxylic dianhydride,
4,4'-oxydiphthalic dianhydride,
1,1,1,3,3,3-hexafluoro-2,2-bis(2,3-dicarboxy-phenyl)propane dianhydride,
1,1,1,3,3,3-hexafluoro-2,2-bis(3,4-dicarboxyphenyl)propane dianhydride,
2,2-bis(2,3-dicarboxyphenyl)propane dianhydride,
2,2-bis(3,4-dicarboxyphenyl)propane dianhydride,
1,1,1,3,3,3-hexafluoro-2,2-bis[4-(2,3-dicarboxyphenoxy)phenyl]propane dianhydride,
1,1,1,3,3,3-hexafluoro-2,2-bis[4-(3,4-dicarboxyphenoxy)phenyl]propane dianhydride.

As the diamine compound, aromatic diamines, heterocyclic diamines and aliphatic diamines can be used.

Examples of the aromatic diamines are as follows:
p-phenylenediamine,
m-phenylenediamine,
p-xylylenediamine,
m-xylylenediamine,
1,5-diaminonaphthalene,
benzidine,
3,3'-dimethylbenzidine,
3,3'-dimethoxybenzidine,
4,4'-(or 3,4'-, 3,3'-, or 2,4'-)diaminodiphenylmethane,
4,4'-(or 3,4'-, 3,3'-, or 2,4'-)diaminodiphenyl ether,
4,4'-(or 3,4'-, 3,3'-, or 2,4'-)diaminodiphenylsulfone,
4,4'-(or 3,4'-, 3,3'-, or 2,4'-)diaminodiphenylsulfide,
4,4'-benzophenonediamine,
3,3'-benzophenonediamine,
4,4'-di(4-aminophenoxy)phenylsulfone,
4,4'-bis(4-aminophenoxy)biphenyl,
1,4-bis(4-aminophenoxy)benzene,
1,3-bis(4-aminophenoxy)benzene,
1,1,1,3,3,3-hexafluoro-2,2-bis(4-aminophenyl)-propane,
2,2-bis[4-(4-aminophenoxy)phenyl]propane,
3,3'-dimethyl-4,4'-diaminodiphenylmethane,
3,3',5,5'-tetramethyl-4,4'-diaminodiphenylmethane,
4,4'-di(3-aminophenoxy)phenylsulfone,
3,3'-diaminodiphenylsulfone,
2,2'-bis(4-aminophenyl)propane.

Examples of the heterocyclic diamines are as follows:
2,6-diaminopyridine,
2,4-diaminopyrimidine,
2,4-diamino-s-triazine,
2,7-diaminodibenzofuran,
2,7-diaminocarbazole,
3,7-diaminophenothiazine,
2,5-diamino-1,3,4-thiadiazole,
2,4-diamino-6-phenyl-s-triazine.

Examples of the aliphatic diamines are as follows:
trimethylenediamine,
tetramethylenediamine,
hexamethylenediamine,
2,2-dimethylpropylenediamine,
diaminopolysiloxanes of the formula: 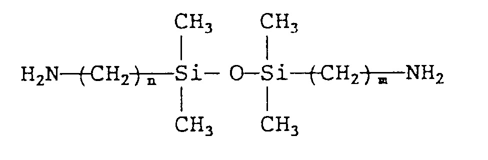 wherein n and m are the same or different integers of 1 to 10.

These tetracarboxylic dianhydrides and diamine compounds can be used singly or as a mixture thereof.

### (H) Cellulose esters

Cellulose esters such as methyl cellulose, ethyl cellulose.

By adding the organic polymer having a high molecular weight to the photosensitive composition, it is possible to improve adhesiveness to a substrate, chemical resistance, film forming properties. The organic polymer having a high molecular weight can preferably be added in an amount of 20 to 80% by weight based on the total weights of the organic polymer having a high molecular weight and the addition polymerizable compound from the viewpoint of photocurability.

In case of adding the organic polymer having a high molecular weight to the photosensitive composition, an amount of using the photoinitiator composition (A) or (B) is the same as the amount of using the photo-initiator composition (A) or (B) described above.

Preferable examples of the photosensitive composition of the present invention are as follows:
(i) a combination of N-(p-cyanophenyl)-glycine, 7-diethylamino-3-thienylcarbonyl-coumarin, bis(cyclopentadienyl)-bis[2,6-difluoro-3-(pyrrol-1-yl)phenyl]titanium, 3'-dimethylaminopropyl methacrylate and poly(amic acid) obtained by reacting 4,4'-diaminodiphenyl ether with pyromellitic dianhydride, and
(ii) a combination of N-(p-methylsulfonylphenyl)-N-methylglycine, 7-diethylamino-3-thienylcarbonyl-coumarin, 2,6-bis(p-N,N-diethylaminobenzal)-4-methyl-4-azacyclohexanone, 3'-dimethylaminopropyl methacrylate and poly(amic acid) obtained by reacting 4,4'-diaminodiphenyl ether with pyromellitic dianhydride.

The photosensitive composition may further contain, if necessary, one or more colorants such as dyes, pigments, etc.

- Examples of the colorants are fuchsin, Crystal Violet, Methyl Orange, Nile Blue 2B, Victoria pure blue, Malachite Green, Night Green B, Spilon Blue, etc.

In order to enhance stability of the photosensitive composition during storage, it is possible to add a radical polymerization inhibitor or a radical polymerization retarder. Examples of such an inhibitor or retarder are p-methoxyphenol, p-benzoquinone, hydroquinone, pyrogallol, naphthylamine, phenothiazine, aryl phosphite, nitrosoamine, etc.

The photosensitive composition of the present invention can be used as a photosensitive resin composition. Further, the photosensitive composition of the present invention can contain one or more other additives such as plasticizers, adhesion promoting agents, etc.

The photosensitive material of the present invention comprises
(a) a poly(amic acid) such as that mentioned above,
(b) a compound having one or more carbon-carbon double bonds dimerizable or polymerizable by actinic radiation and one or more amino groups or a quaternary salt thereof, said compound being selected from the addition polymerizable compound having a boiling point of 100°C or higher under 1 atmosphere, and
(c) a photoinitiator composition (A) or (B).

The poly(amic acid) (a) is preferably used in an equimolar amount in terms of the carboxyl group of the poly(amic acid) with regard to the compound (b). The photoinitiator composition (c) is preferably used in an amount of 0.01 to 30% by weight, more preferably 0.05 to 10% by weight, based on the weight of the compound (b).

Examples of the compound (b), that is, the compound having one or more carbon-carbon double bonds dimerizable or polymerizable by actinic radiation and one or more amino groups or a quaternary salt thereof, are as follows:

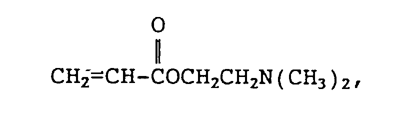

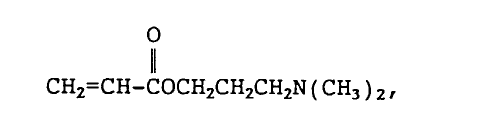

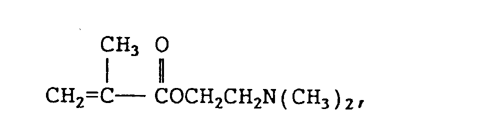

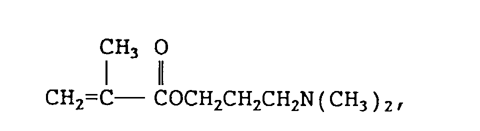

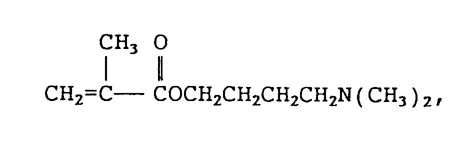

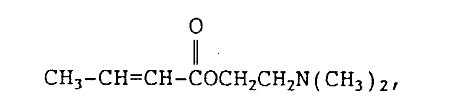

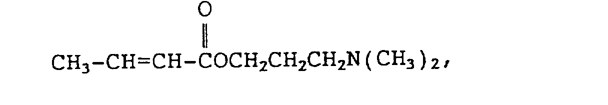

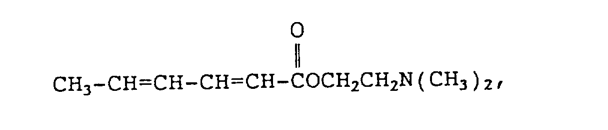

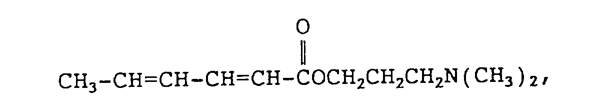

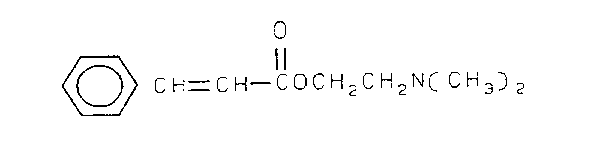

The photosensitive material may contain one or more bisazide compounds.

Examples of the bisazide compounds are as follows:

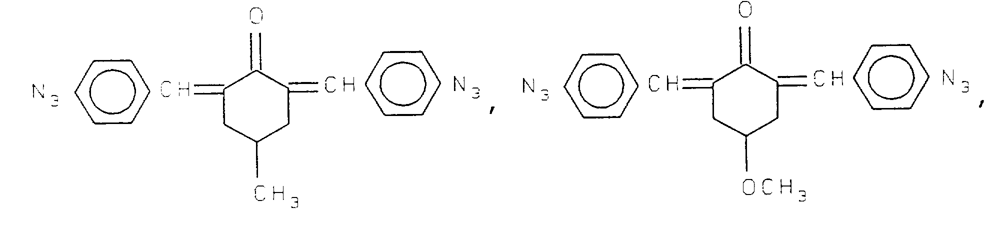

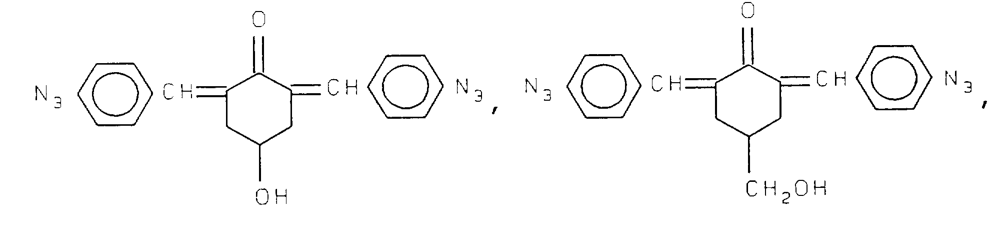

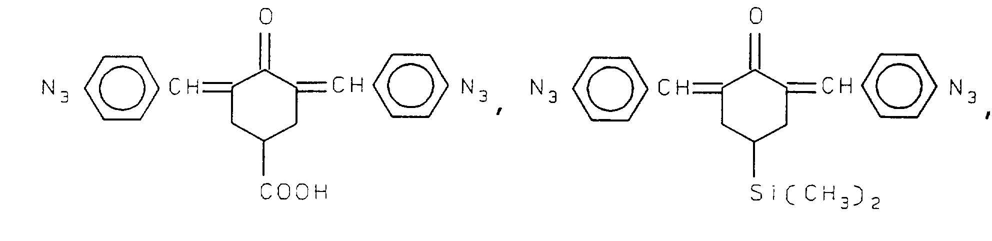

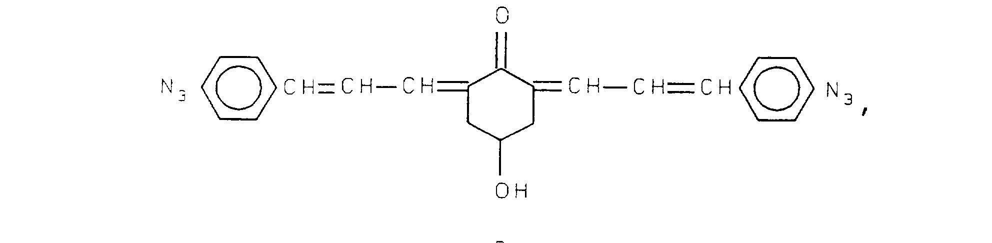

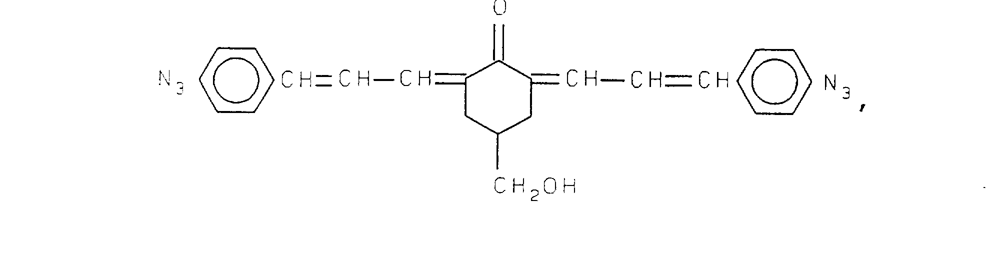

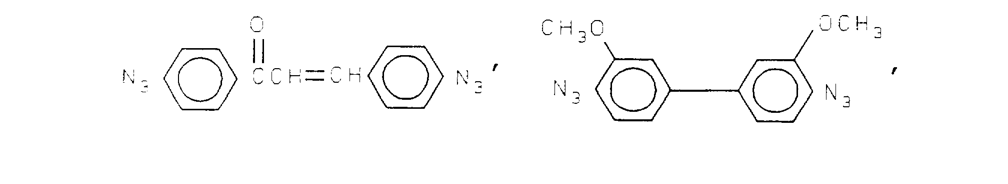

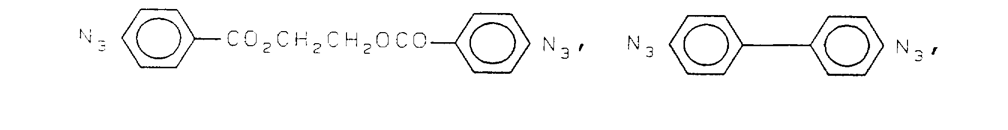

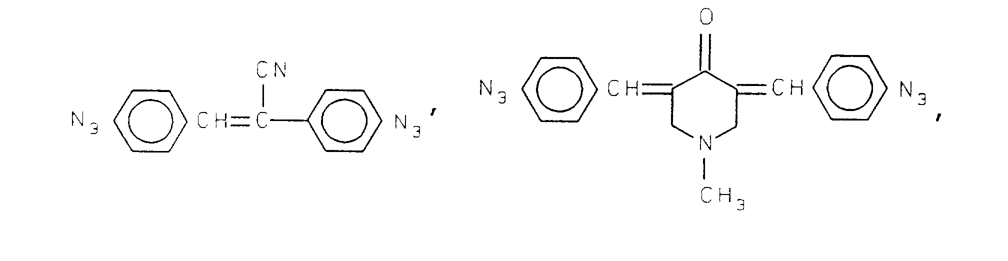

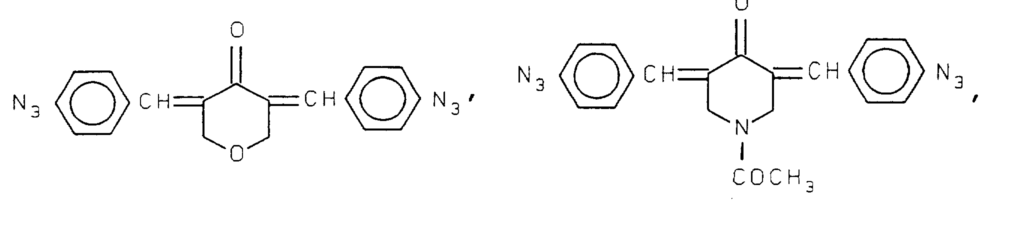

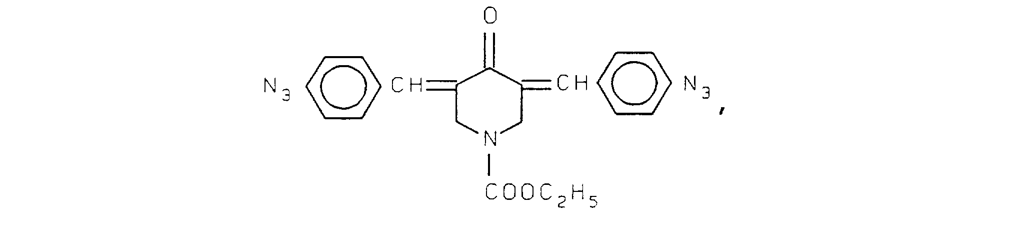

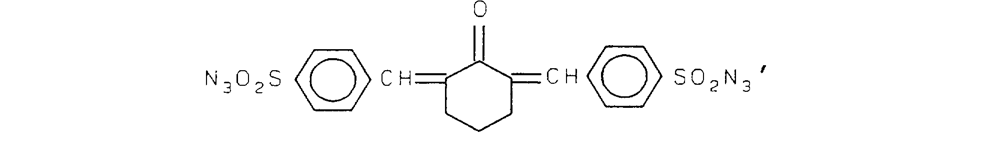

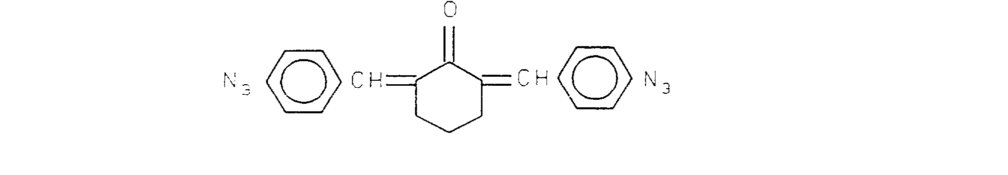

The bisazide compound is preferably used in an amount of 0.01 to 10% by weight based on the weight of the poly(amic acid) (a).

As a solvent for the photosensitive material, there can be used N,N-dimethylacetamide, N,N-dimethylformamide, N-methyl-2-pyrrolidone, γ-butyrolactone, dimethylsulfoxide, sulfolane, etc., or a mixture of at least one solvent mentioned above and xylene, toluene, methyl ethyl ketone, diethyl ketone.

The process for forming a pattern of the present invention comprises coating the photosensitive material on a substrate, drying the photosensitive material, exposing the photosensitive material to light, and developing the photosensitive material to give the desired pattern.

More concretely, the pattern formation is carried out as follows. The photosensitive material is coated on a substrate such as a silicon wafer, a metallic substrate, a glass substrate, a ceramic substrate, or the like, by an immersion method, a spray method, a screen printing method, a spin coating method, etc. Almost of the solvent can be removed by drying with heating to form a coated film without sticking properties. On the coated film, a mask having a desired pattern is placed and subjected to irradiation of actinic radiation. Examples of the actinic radiation are ultraviolet light, deep ultraviolet light, visible light, electron beams, X-rays. After exposure to light, non-exposed portions are removed by a suitable developing solution to give a desired pattern. As the developing solution, there can be used good solvents such as N,N-dimethylformamide, N,N-dimethylacetamide, N-methyl-2-pyrrolidone, and a mixture of such a good solvent and a poor solvent such as lower alcohols, water, aromatic hydrocarbons, etc. After development, rinse is carried out, if necessary, with a poor solvent, followed by drying at about 100°C to make the pattern stable.

The present invention is illustrated by way of Examples, in which all percents are by weight unless otherwise specified.

### Example 1

### Synthesis of N-(p-methylsulfonylphenyl)-N-methylglycine (Compound No. 1)

In a 500-ml pear-shaped flask, 4-fluorophenylmethylsulfone (15.01 g, 86.26 mmoles), N-methylglycine (8.45 g, 94.89 mmoles) and potassium carbonate (14.28 g, 103.48 mmoles) were placed, followed by addition of 1200 ml of dimethylsulfoxide as a solvent. A water cooling pipe was attached to the flask and the reaction was carried out with heating on an oil bath heated at 100°C for 9 hours with stirring using a magnetic stirrer. After cooling naturally, the reaction mixture was dissolved in 1 liter of water, and subjected to acidolysis with 1/10N HCℓ, followed by filtration of a precipitate. After washing with water well, the precipitate was washed with hexane/benzene (4/1 in volume ratio). The yield of the product after dried was 12.13 g (49.92 mmoles, 57.9%). The melting point was 161.2°C.

### Example 2

### Synthesis of N-(p-cyanophenyl)-glycine (Compound No. 2)

In a 500-ml three-necked flask, 4-cyanoaniline (100 g, 847.4 mmoles) was placed, followed by addition of 300 ml of water and attachment of a water cooling pipe, a mechanical stirrer and a dropping funnel. The flask was heated on an oil bath heated at 100°C. To the flask, an aqueous solution (water 150 ml) of monochloroacetic acid (104 g, 1116 mmoles) was added dropwise for about 30 minutes, followed by reflux with heating for 2.5 hours. After cooling naturally, about 100 ml of ethyl acetate was added to the flask to dissolve an insoluble matter. An organic layer was separated by a separatory funnel. The residual water layer and an aqueous layer obtained by extracting the organic layer with 100 ml of 5% (by weight) NaOH solution were combined, followed by acidolysis with 1/10N HCℓ. A precipitate produced was filtered and washed with water several times. After drying in an oven heated at 60°C for 3 hours, the dried precipitate was dried in a vacuum desiccator overnight. The resulting product was a beige powder which showed no melting point but decomposed at 233.1°C. The yield was 38.8 g (26%).

### Example 3

### Synthesis of N-(p-cyanophenyl)-N-methylglycine (Compound No. 3)

In a 500-ml pear-shaped flask, 4-fluorobenzonitrile (10.44 g, 86.26 mmoles), N-methylglycine (8.45 g, 94.89 mmoles) and potassium carbonate (14.28 g, 103.48 mmoles) were placed, followed by addition of 200 ml of dimethylsulfoxide as a solvent. A water cooling pipe was attached to the flask, and the reaction was carried out with heating on an oil bath heated at 100°C for 9 hours with stirring using a magnetic stirrer. After cooling naturally, the reaction mixture was dissolved in 1 liter of water and subjected to acidolysis with 1/10N HCℓ, followed by filtration of a precipitate. After washing with water well, the precipitate was washed with hexane/benzene (4/1 in volume ratio). The yield of the product after dried was 14.21 g (74.79 mmoles, 86.7%). The melting point was 64.5°C.

The structure of the Compound Nos. 1 to 3 was confirmed by H¹-NMR spectra shown in Table 1.

**Table 1**

| Compound No. | Chemical shift | Number of proton | Kind of proton | Coupling constant (Hz) |
|---|---|---|---|---|
| 1 | 3.00(s) | 3H | CH₃SO₃-Ar- | - |
| | 3.15(s) | 3H | N-CH₃ | - |
| | 4.11(s) | 2H | N-CH₂-CO₂H | - |
| | 6.73(d) | 2H | Ar-H | 9.03 |
| | 7.72(d) | 2H | Ar-H | 8.96 |
| 2 | 4.04(d) | 2H | N-CH₂-CO₂H | 5.20 |
| | 6.08(s) | 1H | NH | - |
| | 6.78(d) | 2H | Ar-H | 8.80 |
| | 7.47(d) | 2H | Ar-H | 8.80 |
| 3 | 3.12(s) | 3H | N-CH₃ | - |
| | 4.15(s) | 2H | N-CH₂-CO₂H | - |
| | 6.65(d) | 2H | Ar-H | 9.09 |
| | 7.49(d) | 2H | Ar-H | 9.10 |

### Examples 4 and 5, Comparative Examples 1 and 2

A photosensitive material was prepared by mixing 10 g of N-methyl-2-pyrrolidone solution of poly(amic acid) (solid content 20%) obtained by reacting 4,4'-diaminodiphenyl ether with pyromellitic dianhydride in equimolar amounts, 1.8 g of 2-dimethylaminoethyl methacrylate, and a photoinitiator composition (A) as shown in Table 2 with stirring.

After filtering with a filter, the photosensitive material was spin coated on a silicon wafer. After heating on a hot plate at 100°C for 200 seconds, the solvent was removed to give a photosensitive coated film. The film thickness after dried was 10 µm.

The photosensitive coated film was exposed to light via a photomask using a ultrahigh pressure mercury lamp. The light exposure amount was 500 mJ/cm². The resulting film was subjected to immersion development using a mixed solution of N-methyl-2-pyrrolidone and methyl alcohol (4/1 in volume ratio), followed by rinsing with isopropanol. After development, the shape of pattern was measured and observed. A normalized film thickness after development (NFTAD) (a value obtained by dividing the film thickness by the initial time film thickness) and a minimum open through-hole diameter (open diameter) were shown in Table 2.

In Example 4, wherein N-(p-methylsulfonylphenyl)-N-methylglycine was used for the wafer, the finally cured film was obtained by heating at 100°C for 15 minutes, at 200°C for 20 minutes and at 350°C for 60 minutes in a nitrogen atmosphere. The film thickness of finally cured film was 5 µm with good polyimide pattern.

As shown in Table 2, according to the data of NFTAD and open diameter, the evaluation that the photosensitive materials of the present invention have an excellent resolution can be admitted, therefore the photosensitive materials of the present invention are excellent in photosensitive properties compared with Comparative Examples.

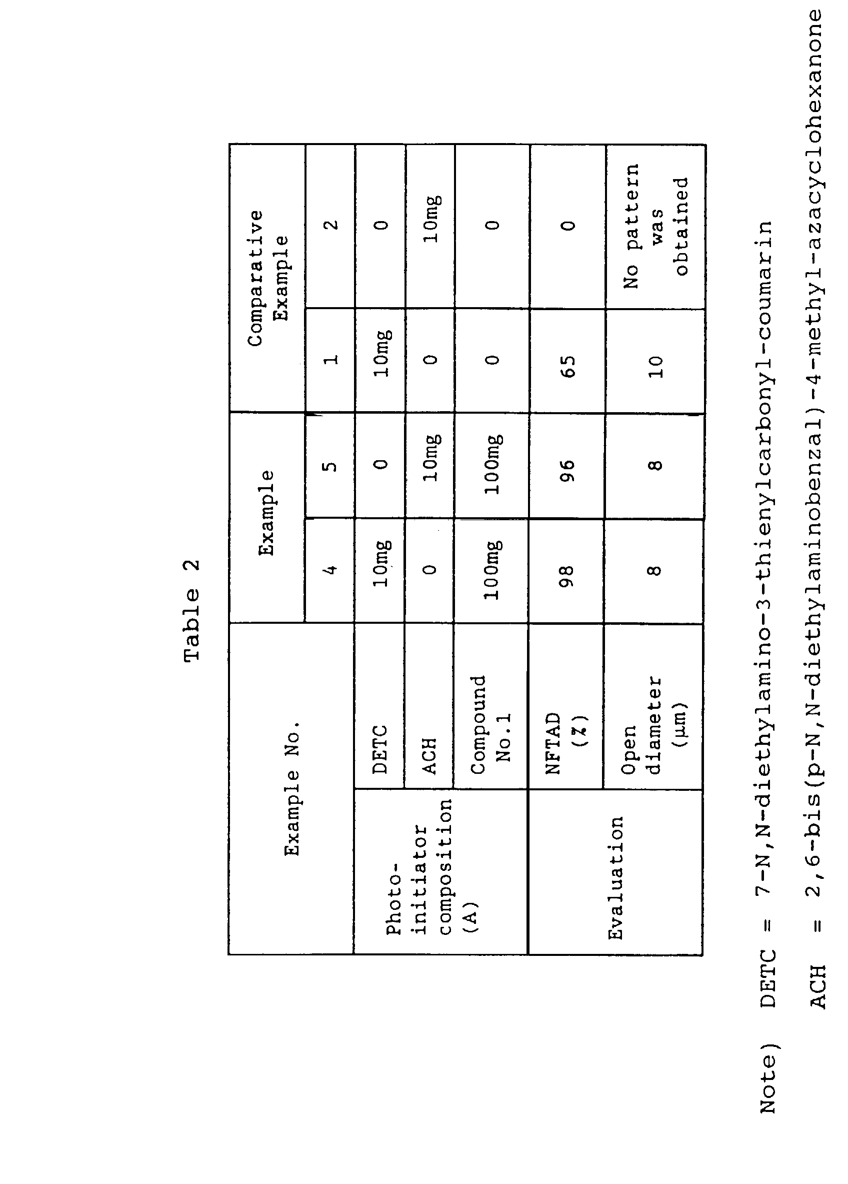

### Example 9 to 11, Reference Examples 6-8, Comparative Examples 3 to 5

N-(p-cyanophenyl)-glycine was synthesized in the same manner as described in Example 2.

N-(p-cyanophenyl)-N-methylglycine was synthesized in the same manner as described in Example 3.

A photosensitive material was prepared by mixing 10 g of N-methyl-2-pyrrolidone solution of poly(amic acid) (solid content 20%) obtained by reacting 4,4'-diaminodiphenyl ether with pyromellitic dianhydride in equimolar amounts, 1.8 g of 2-dimethylaminoethyl methacrylate, and a photoinitiator composition (B) as shown in Table 3 with stirring.

A pattern was formed and the normalized film thickness after development (NFTAD) and open diameter were measured in the same manner as described in Examples 4 and 5, and listed in Table 3. In Table 3, the shape of pattern was also listed.

As to the wafer of Example 9, the finally cured film was obtained by heating at 100°C for 15 minutes, at 200°C for 20 minutes and at 350°C for 60 minutes in a nitrogen atmosphere. The film thickness of finally cured film was 10 µm with good polyimide pattern.

As shown in Table 3, according to the data of NFTAD and the open diameter, the evaluation that the photosensitive materials of the present invention have an excellent resolution can be admitted, therefore the photosensitive materials of the present invention are excellent in photosensitive properties compared with Comparative Examples.

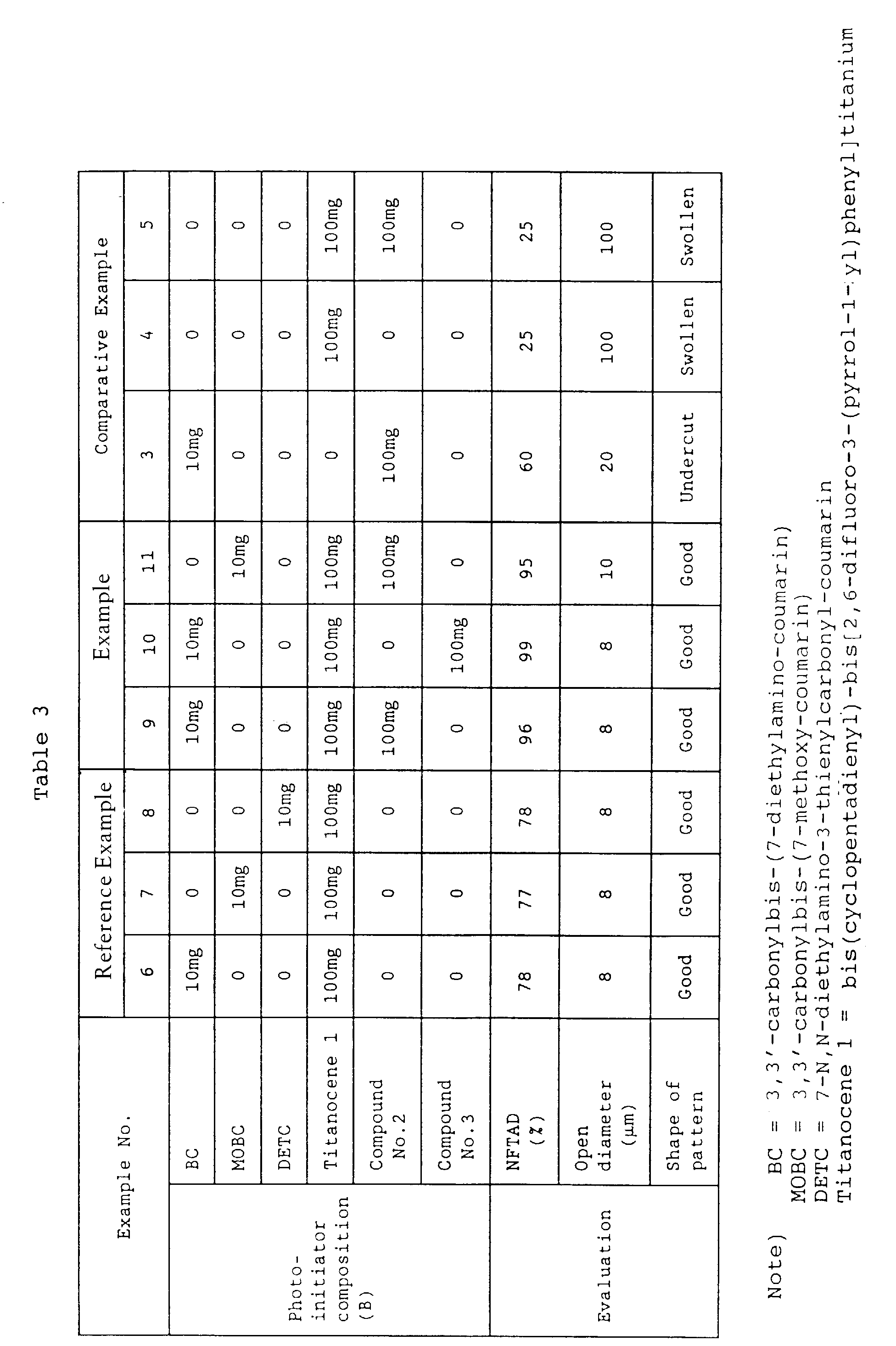

### Examples 15 to 17, Reference Examples 12 to 14 Comparative Examples 6 to 8

To the same photosensitive materials used in Examples 9 to 11, Reference Examples 6 to 8, and Comparative Examples 3 to 5, 20 mg of 4,4'-bisazido-3,3'-dimethoxybiphenyl (AZ) was added and subjected to the same tests as in Examples 6 to 11.

The results are shown in Table 4.

As shown in Table 4, according to the data of NFTAD and open diameter, the evaluation that the photosensitive materials of the present invention have an excellent resolution can be admitted, and by the addition of bisazide compound, the normalized film thickness after development is improved.

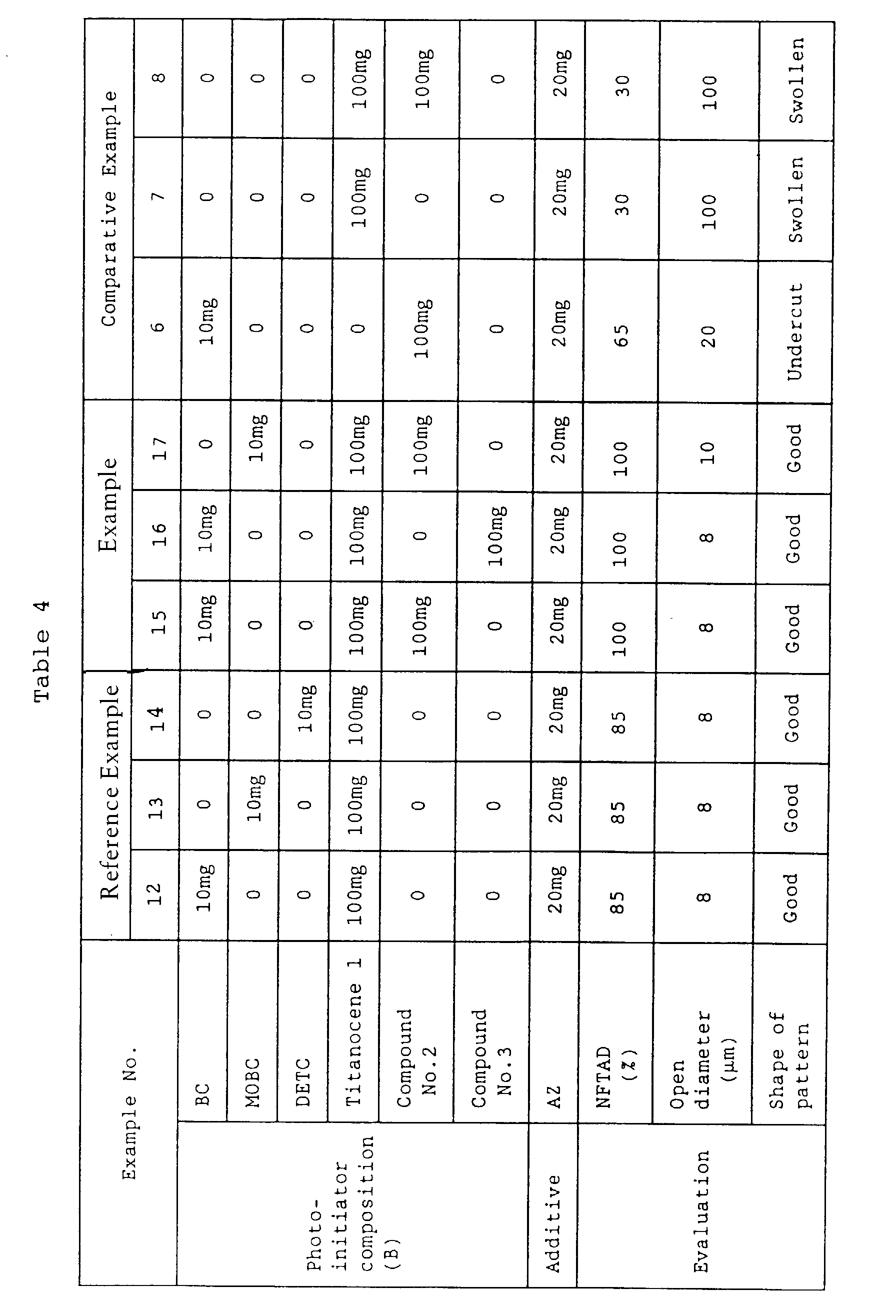

## Claims

1. An N-aryl-α-amino acid of the formula: 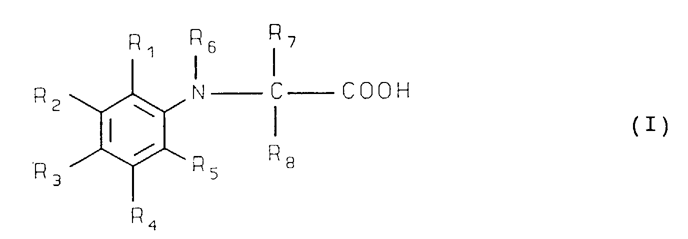 wherein R₁, R₂, R₃, R₄ and R₅ are independently a hydrogen atom, a halogen atom, an alkyl group having 1 to 4 carbon atoms, a cyano group, an alkoxycarbonyl group having 2 to 10 carbon atoms, CONH₂ or an alkylsulfonyl group having 1 to 4 carbon atoms and said alkyl moiety able to be substituted with a cyano group, and at least one of R₁ through R₅ is an alkylsulfonyl group having 1 to 4 carbon atoms; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms.

2. A photoinitiator composition (A) comprising
an N-aryl-α-amino acid of the formula: 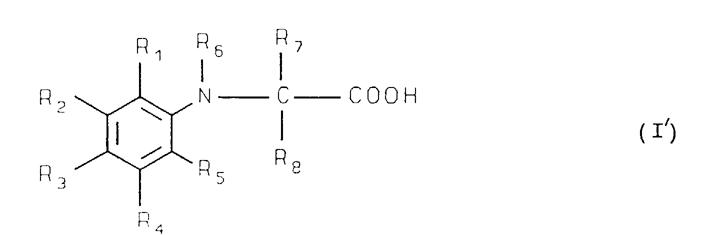 wherein R₁, R₂, R₃, R₄ and R₅ are independently a hydrogen atom, a halogen atom, an alkyl group having 1 to 4 carbon atoms, a cyano group, an alkoxycarbonyl group having 2 to 10 carbon atoms, CONH₂, or an alkylsulfonyl group having 1 to 4 carbon atoms and said alkyl moiety being able to be substituted with a cyano group, and at least one of R₁ through R₅ is an alkoxycarbonyl group having 2 to 10 carbon atoms, CONH₂, or an alkylsulfonyl group having 1 to 4 carbon atoms; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms, and
at least one member selected from the group consisting of a 3-substituted coumarin compound of the formula: 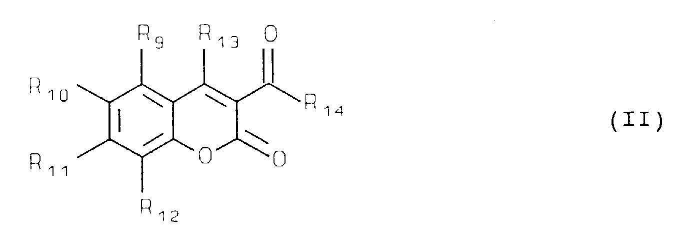 wherein R₉, R₁₀, R₁₁, R₁₂ and R₁₃ are independently a hydrogen atom, an amino group substituted with an alkyl group having 1 to 5 carbon atoms, an amino group substituted with two alkyl groups having 1 to 5 carbon atoms, an alkoxy group having 1 to 5 carbon atoms, an acyloxy group, an aryl group, a halogen atom, or a thioalkyl group having 1 to 5 carbon atoms; and R₁₄ is a non-substituted phenyl group, a biphenyl group, a naphthyl group, a thienyl group, a benzofuryl group, a furyl group, a pyridyl group, a coumarinyl group, an amino group, an amino group substituted with one or more alkyl groups having 1 to 5 carbon atoms, a cyano group, an alkoxy group having 1 to 5 carbon atoms, an alkyl group having 1 to 5 carbon atoms, a halogen atom, a haloalkyl group, a formyl group, an alkoxycarbonyl group having 1 to 5 carbon atoms, an acyloxy group having 1 to 5 carbon atoms, a phenyl group substituted with an acyloxy group having 1 to 5 carbon atoms, a cyano group, an alkoxy group or an acyl group having 1 to 5 carbon atoms, said biphenyl group, said naphthyl group, said thienyl group, said benzofuryl group, said furyl group, said pyridyl group or said coumarinyl group being able to be substituted with an acyloxy group having 1 to 5 carbon atoms or an acyl group having 1 to 5 carbon atoms, and an azabenzalcyclohexanone compound of the formula: 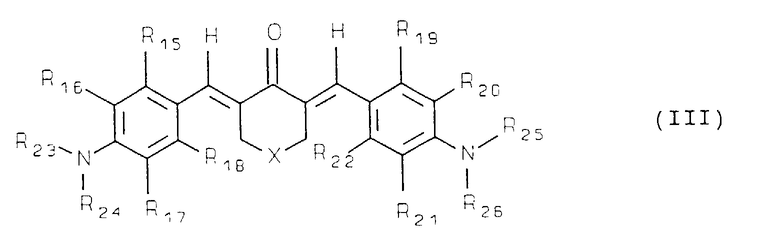 wherein R₁₅, R₁₆, R₁₇, R₁₈, R₁₉, R₂₀, R₂₁ and R₂₂ are independently a hydrogen atom, a chlorine atom, a bromine atom, an alkyl group having 1 to 12 carbon atoms, an aryl group or an alkoxy group having 1 to 12 carbon atoms; and R₂₃, R₂₄, R₂₅ and R₂₆ are independently an alkyl group having 1 to 6 carbon atoms; X is an imino group which may be substituted with an alkyl group having 1 to 12 carbon atoms, an aralkyl group having 7 to 20 carbon atoms, an aryl group, an acyl group having 2 to 12 carbon atoms, an arylcarbonyl group having 7 to 20 carbon atoms, an alkoxycarbonyl group having 2 to 12 carbon atoms, or an aryloxycarbonyl group having 7 to 20 carbon atoms.

3. A photosensitive composition comprising
an addition photo-polymerizable compound having a boiling point of 100°C or higher under 1 atmosphere, and
a photoinitiator composition (A) of claim 2.

4. A photosensitive composition according to claim 3, which further comprises one or more organic polymers having a high molecular weight.

5. A photosensitive material comprising
(a) a poly(amic acid),
(b) a compound having one or more carbon-carbon double bonds dimerizable or polymerizable by actinic radiation and one or more amino groups or a quaternary salt thereof, and
(c) a photoinitiator composition (A) of claim 2.

6. A photosensitive material according to claim 5, which further comprises one or more bisazide compounds.

7. Use of a photosensitive material of claim 5 for forming a pattern.

8. A photoinitiator composition (B) comprising
an N-aryl-α-amino acid of the formula: 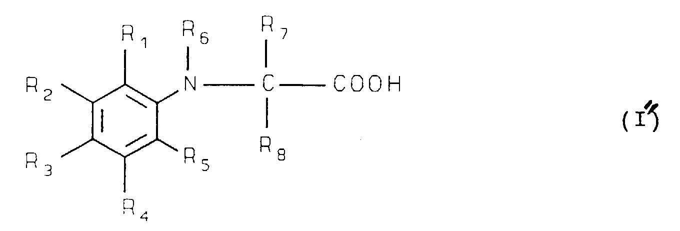 wherein R₁, R₂, R₃, R₄ and R₅ are independently a hydrogen atom, an alkyl group having 1 to 4 carbon atoms, a cyano group, an alkoxycarbonyl group having 2 to 10 carbon atoms, CONH₂, or an alkylsulfonyl group having 1 to 4 carbon atoms and said alkyl moiety being able to be substituted with a cyano group, with the proviso that R₁ through R₅ cannot all be hydrogen atoms at the same time; R₆ is a hydrogen atom, an alkyl group having 1 to 12 carbon atoms, a cycloalkyl group, a hydroxyalkyl group having 1 to 12 carbon atoms, an alkoxyalkyl group having 2 to 12 carbon atoms, an aminoalkyl group having 1 to 12 carbon atoms, or an aryl group; and R₇ and R₈ are independently a hydrogen atom or an alkyl group having 1 to 8 carbon atoms,
a 3-substituted coumarin compound of the formula: 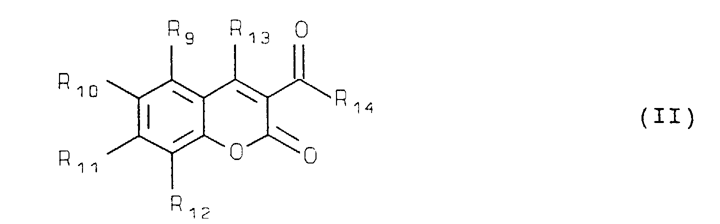 wherein R₉, R₁₀, R₁₁, R₁₂ and R₁₃ are independently a hydrogen atom, an amino group substituted with an alkyl group having 1 to 5 carbon atoms, an amino group substituted with two alkyl groups having 1 to 5 carbon atoms, an alkoxy group having 1 to 5 carbon atoms, an acyloxy group, an aryl group, a halogen atom, or a thioalkyl group having 1 to 5 carbon atoms; and R₁₄ is a non-substituted phenyl group, a biphenyl group, a naphthyl group, a thienyl group, a benzofuryl group, a furyl group, a pyridyl group, a coumaryl group, an amino group, an amino group substituted with one or more alkyl groups having 1 to 5 carbon atoms, a cyano group, an alkoxy group having 1 to 5 carbon atoms, an alkyl group having 1 to 5 carbon atoms, a halogen atom, a haloalkyl group, a formyl group, an alkoxycarbonyl group having 1 to 5 carbon atoms, an acyloxy group having 1 to 5 carbon atoms, a phenyl group substituted with an acyloxy group having 1 to 5 carbon atoms, a cyano group, an alkoxy group or an acyl group having 1 to 5 carbon atoms, said biphenyl group, said naphthyl group, said thienyl group, said benzofuryl group, said furyl group, said pyridyl group or said coumarinyl group being able to be substituted with an acyloxy group having 1 to 5 carbon atoms or an acyl group having 1 to 5 carbon atoms, and
a titanocene compound of the formula: 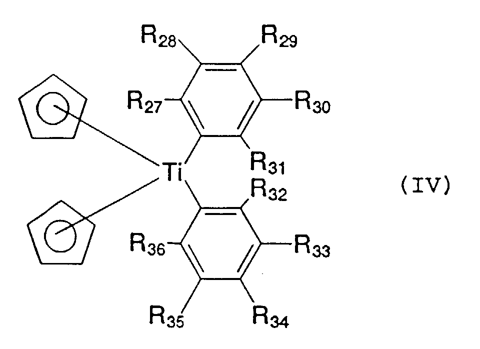 wherein R₂₇ through R₃₆ are independently a hydrogen atom, a halogen atom, an alkoxy group having 1 to 20 carbon atoms or a heterocyclic ring, said heterocyclic ring being bound to a benzene ring via an alkylene group or substituted with one or more alkyl groups, amino groups and alkoxy groups.

9. A photosensitive composition comprising
an addition photo-polymerizable compound having a boiling point of 100°C or higher under 1 atmosphere, and
a photoinitiator composition (B) of claim 8.

10. A photosensitive composition according to claim 9, which further comprises one or more organic polymers having a high molecular weight.

11. A photosensitive material comprising
(a) a poly(amic acid),
(b) a compound having one or more carbon-carbon double bonds dimerizable or polymerizable by actinic radiation and one or more amino groups or a quaternary salt thereof, and
(c) a photoinitiator composition (B) of claim 8.

12. A photosensitive material according to claim 11, which further comprises one or more bisazide compounds.

13. Use of a photosensitive material of claim 11 for forming a pattern.

14. A process for forming a pattern, which comprises coating a photosensitive material of claim 5 or 11 on a substrate, drying the photosensitive material, exposing the photosensitive material to light, and developing the photosensitive material.

15. Use of an N-aryl-α-amino acid of the formula (I') as defined in claim 2 as a photoinitiator.

## Patentansprüche

1. N-Aryl-α-aminosäure der Formel: 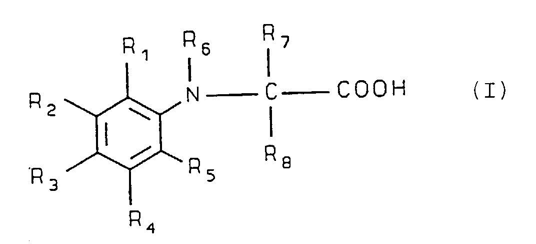 worin R₁, R₂, R₃, R₄ und R₅ unabhängig voneinander ein Wasserstoffatom, ein Halogenatom, eine Alkylgruppe mit 1 bis 4 Kohlenstoffatomen, eine Cyanogruppe, eine Alkoxycarbonylgruppe mit 2 bis 10 Kohlenstoffatomen, eine CONH₂-oder eine Alkylsulfonylgruppe mit 1 bis 4 Kohlenstoffatomen sind und wobei die genannte Alkylgruppierung durch eine Cyanogruppe substituiert sein kann und wobei mindestens eine der Gruppen R₁ bis R₅ eine Alkylsulfonylgruppe mit 1 bis 4 Kohlenstoffatomen ist, R₆ für ein Wasserstoffatom, eine Alkylgruppe mit 1 bis 12 Kohlenstoffatomen, eine Cycloalkylgruppe, eine Hydroxyalkylgruppe mit 1 bis 12 Kohlenstoffatomen, eine Alkoxyalkylgruppe mit 2 bis 12 Kohlenstoffatomen, eine Aminoalkylgruppe mit 1 bis 12 Kohlenstoffatomen oder eine Arylgruppe ist, und R₇ und R₈ unabhängig voneinander für ein Wasserstoffatom oder eine Alkylgruppe mit 1 bis 8 Kohlenstoffatomen stehen.

2. Photoinitiator (A), umfassend eine N-Aryl-α-aminosäure der Formel: 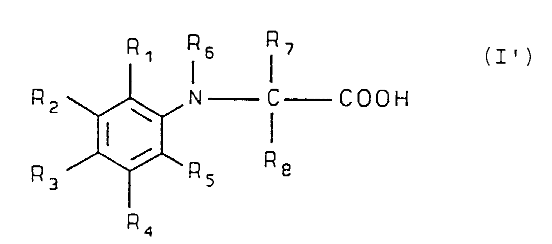 worin R₁, R₂, R₃, R₄ und R₅ unabhängig voneinander ein Wasserstoffatom, ein Halogenatom, eine Alkylgruppe mit 1 bis 4 Kohlenstoffatomen, eine Cyanogruppe, eine Alkoxycarbonylgruppe mit 2 bis 10 Kohlenstoffatomen, eine CONH₂-oder eine Alkylsulfonylgruppe mit 1 bis 4 Kohlenstoffatomen sind und wobei die genannte Alkylgruppierung durch eine Cyanogruppe substituiert sein kann und wobei mindestens eine der Gruppen R₁ bis R₅ eine Alkoxycarbonylgruppe mit 2 bis 20 Kohlenstoffatomen, eine CONH₂- oder eine Alkylsulfonylgruppe mit 1 bis 4 Kohlenstoffatomen ist, R₆ für ein Wasserstoffatom, eine Alkylgruppe mit 1 bis 12 Kohlenstoffatomen, eine Cycloalkylgruppe, eine Hydroxyalkylgruppe mit 1 bis 12 Kohlenstoffatomen, eine Alkoxyalkylgruppe mit 2 bis 12 Kohlenstoffatomen, eine Aminoalkylgruppe mit 1 bis 12 Kohlenstoffatomen oder eine Arylgruppe ist, und R₇ und R₈ unabhängig voneinander für ein Wasserstoffatom oder eine Alkylgruppe mit 1 bis 8 Kohlenstoffatomen stehen und mindestens eine Substanz, ausgewählt aus der Gruppe bestehend aus 3-substituierten Cumarinverbindungen der Formel: 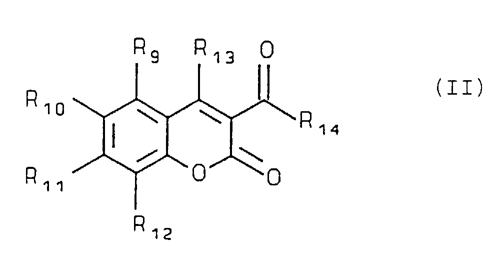 worin R₉, R₁₀, R₁₁, R₁₂ und R₁₃ unabhängig voneinander für ein Wasserstoffatom, eine Aminogruppe, die mit einer Alkylgruppe mit 1 bis 5 Kohlenstoffatomen substituiert ist, eine Aminogruppe, die mit zwei Alkylgruppen mit 1 bis 5 Kohlenstoffatomen substituiert ist, eine Alkoxygruppe mit 1 bis 5 Kohlenstoffatomen, eine Acyloxygruppe, eine Arylgruppe, ein Halogenatom oder eine Thioalkylgruppe mit 1 bis 5 Kohlenstoffatomen stehen, und R₁₄ eine nichtsubstituierte Phenylgruppe, eine Biphenylgruppe, eine Naphthylgruppe, eine Thienylgruppe, eine Benzofurylgruppe, eine Furylgruppe, eine Pyridylgruppe, eine Cumarinylgruppe, eine Aminogruppe, eine Aminogruppe, die mit einer oder mehreren Alkylgruppen mit 1 bis 5 Kohlenstoffatomen, einer Cyanogruppe, einer Alkoxygruppe mit 1 bis 5 Kohlenstoffatomen, einer Alkylgruppe mit 1 bis 5 Kohlenstoffatomen, einem Halogenatom, einer Halogenalkylgruppe, einer Formylgruppe, einer Alkoxycarbonylgruppe mit 1 bis 5 Kohlenstoffatomen, einer Acyloxygruppe mit 1 bis 5 Kohlenstoffatomen, einer Phenylgruppe, substituiert mit einer Acyloxygruppe mit 1 bis 5 Kohlenstoffatomen, einer Cyanogruppe, einer Alkoxygruppe oder einer Acylgruppe mit 1 bis 5 Kohlenstoffatomen substituiert ist, ist, wobei die genannte Biphenylgruppe, die genannte Naphthylgruppe, die genannte Thienylgruppe, die genannte Benzofurylgruppe, die genannte Furylgruppe, die genannte Pyridylgruppe oder die genannte Cumarinylgrupppe mit einer Acyloxygruppe mit 1 bis 5 Kohlenstoffatomen oder einer Acylgruppe mit 1 bis 5 Kohlenstoffatomen substituiert sein kann, und eine Azabenzalcyclohexanonverbindung mit der Formel: 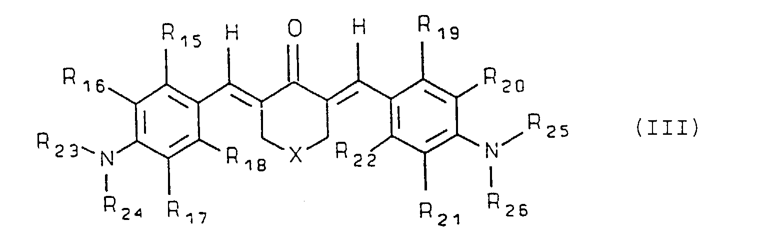 worin R₁₅, R₁₆, R₁₇, R₁₈, R₁₉, R₂₀, R₂₁ und R₂₂ unabhängig voneinander für ein Wasserstoffatom, ein Chloratom, ein Bromatom, eine Alkylgruppe mit 1 bis 12 Kohlenstoffatomen, eine Arylgruppe oder eine Alkoxygruppe mit 1 bis 12 Kohlenstoffatomen stehen und R₂₃, R₂₄, R₂₅ und R₂₆ unabhängig voneinander für eine Alkylgruppe mit 1 bis 6 Kohlenstoffatomen stehen, X für eine Iminogruppe, die mit einer Alkylgruppe mit 1 bis 12 Kohlenstoffatomen, einer Aralkylgruppe mit 7 bis 20 Kohlenstoffatomen, einer Arylgruppe, einer Acylgruppe mit 2 bis 12 Kohlenstoffatomen, einer Arylcarbonylgruppe mit 7 bis 20 Kohlenstoffatomen, einer Alkoxycarbonylgruppe mit 2 bis 12 Kohlenstoffatomen oder einer Aryloxycarbonylgruppe mit 7 bis 20 Kohlenstoffatomen substituiert sein kann, steht.

3. Lichtempfindliche Masse, umfassend eine Additionsphotopolymerisierbare Verbindung mit einem Siedepunkt von 100°C oder höher unter 1 Atmosphäre, und einem Photoinitiator (A) nach Anspruch 2.

4. Lichtempfindliche Masse nach Anspruch 3, dadurch **gekennzeichnet**, daß sie weiterhin ein oder mehrere organische Polymere mit hohem Molekulargewicht enthält.

5. Lichtempfindliches Material, enthaltend
(a) eine Poly(aminsäure),
(b) eine Verbindung mit ein oder mehreren Kohlenstoff-Kohlenstoff-Doppelbindungen, die durch aktinische Strahlen dimerisierbar oder polymerisierbar sind, und ein oder mehrere Aminogruppe(n) oder ein quaternäres Salz davon und
(c) einen Photoinitiator (A) nach Anspruch 2.

6. Lichtempfindliches Material nach Anspruch 5, dadurch **gekennzeichnet**, daß es weiterhin ein oder mehrere Bisazidverbindungen enthält.

7. Verwendung des lichtempfindlichen Materials nach Anspruch 5 zur Bildung eines Musters.

8. Photoinitiator (B), umfassend eine N-Aryl-α-aminosäure der Formel: 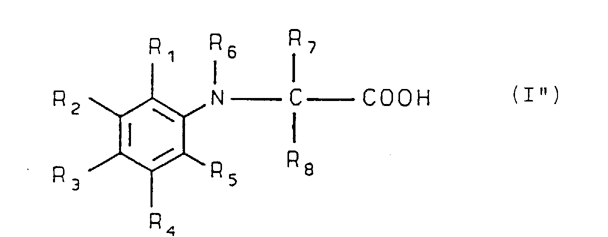 worin R₁, R₂, R₃, R₄ und R₅ unabhängig voneinander ein Wasserstoffatom, eine Alkylgruppe mit 1 bis 4 Kohlenstoffatomen, eine Cyanogruppe, eine Alkoxycarbonylgruppe mit 2 bis 10 Kohlenstoffatomen, eine CONH₂- oder eine Alkylsulfonylgruppe mit 1 bis 4 Kohlenstoffatomen sind und wobei die genannte Alkylgruppierung durch eine Cyanogruppe substituiert sein kann, mit der Maßgabe, daß R₁ bis R₅ nicht gleichzeitig alle Wasserstoffatome sein können, R₆ für ein Wasserstoffatom, eine Alkylgruppe mit 1 bis 12 Kohlenstoffatomen, eine Cycloalkylgruppe, eine Hydroxyalkylgruppe mit 1 bis 12 Kohlenstoffatomen, eine Alkoxyalkylgruppe mit 2 bis 12 Kohlenstoffatomen, eine Aminoalkylgruppe mit 1 bis 12 Kohlenstoffatomen oder eine Arylgruppe ist, und R₇ und R₈ unabhängig voneinander für ein Wasserstoffatom oder eine Alkylgruppe mit 1 bis 8 Kohlenstoffatomen stehen, eine 3-substituierte Cumarinverbindung der Formel: 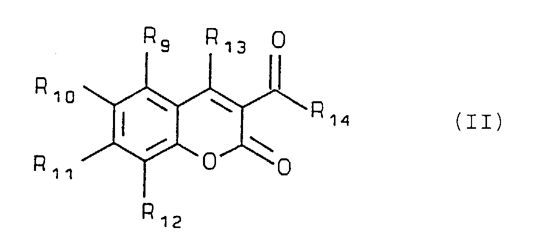 worin R₉, R₁₀, R₁₁, R₁₂ und R₁₃ unabhängig voneinander für ein Wasserstoffatom, eine Aminogruppe, die mit einer Alkylgruppe mit 1 bis 5 Kohlenstoffatomen substituiert ist, eine Aminogruppe, die mit zwei Alkylgruppen mit 1 bis 5 Kohlenstoffatomen substituiert ist, eine Alkoxygruppe mit 1 bis 5 Kohlenstoffatomen, eine Acyloxygruppe, eine Arylgruppe, ein Halogenatom oder eine Thioalkylgruppe mit 1 bis 5 Kohlenstoffatomen stehen, und R₁₄ eine nichtsubstituierte Phenylgruppe, eine Biphenylgruppe, eine Naphthylgruppe, eine Thienylgruppe, eine Benzofurylgruppe, eine Furylgruppe, eine Pyridylgruppe, eine Cumarinylgruppe, eine Aminogruppe, eine Aminogruppe, die mit einer oder mehreren Alkylgruppen mit 1 bis 5 Kohlenstoffatomen, einer Cyanogruppe, einer Alkoxygruppe mit 1 bis 5 Kohlenstoffatomen, einer Alkylgruppe mit 1 bis 5 Kohlenstoffatomen, einem Halogenatom, einer Halogenalkylgruppe, einer Formylgruppe, einer Alkoxycarbonylgruppe mit 1 bis 5 Kohlenstoffatomen, einer Acyloxygruppe mit 1 bis 5 Kohlenstoffatomen, einer Phenylgruppe, substituiert mit einer Acyloxygruppe mit 1 bis 5 Kohlenstoffatomen, einer Cyanogruppe, einer Alkoxygruppe oder einer Acylgruppe mit 1 bis 5 Kohlenstoffatomen substituiert ist, ist, wobei die genannte Biphenylgruppe, die genannte Naphthylgruppe, die genannte Thienylgruppe, die genannte Benzofurylgruppe, die genannte Furylgruppe, die genannte Pyridylgruppe oder die genannte Cumarinylgrupppe mit einer Acyloxygruppe mit 1 bis 5 Kohlenstoffatomen oder einer Acylgruppe mit 1 bis 5 Kohlenstoffatomen substituiert sein kann und eine Titanocenverbindung der Formel: 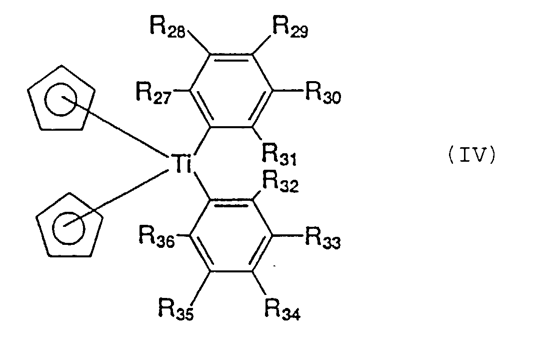 worin R₂₇ bis R₃₆ unabhängig voneinander für ein Wasserstoffatom, ein Halogenatom, eine Alkoxygruppe mit 1 bis 20 Kohlenstoffatomen oder einen heterocyclischen Ring stehen, wobei der genannte heterocyclische Ring direkt oder auf dem Wege über eine Alkylengruppe an einen Benzolring gebunden ist und durch eine oder mehrere Alkylgruppen, Aminogruppen, Alkylaminogruppen und Alkoxygruppen substituiert sein kann.

9. Lichtempfindliche Masse, umfassend eine Additionsphotopolymerisierbare Verbindung mit einem Siedepunkt von 100°C oder höher unter 1 Atmosphäre und einen Photoinitiator (B) nach Anspruch 8.

10. Lichtempfindliche Masse nach Anspruch 9, dadurch **gekennzeichnet**, daß sie weiterhin ein oder mehrere organische Polymere mit hohem Molekulargewicht enthält.

11. Lichtempfindliches Material, enthaltend
(a) eine Poly(aminsäure),
(b) eine Verbindung mit einer oder mehreren Kohlenstoff-Kohlenstoff-Doppelbindungen, die durch aktinische Strahlung dimerisierbar oder polymerisierbar sind, und einer oder mehreren Aminogruppen oder ein quaternäres Salz davon und
(c) einen Photoinitiator (B) nach Anspruch 8.

12. Lichtempfindliches Material nach Anspruch 11, dadurch **gekennzeichnet**, daß es weiterhin eine oder mehrere Bisazidverbindungen enthält.

13. Verwendung des lichtempfindlichen Materials nach Anspruch 11 zur Bildung eines Musters bzw. einer Schablone.

14. Verfahren zur Bildung eines Musters bzw. einer Schablone, umfassend Aufschichten eines lichtempfindlichen Materials nach Anspruch 5 oder 11 auf ein Substrat, Trocknen des lichtempfindlichen Materials, Belichten des lichtempfindlichen Materials und Entwickeln des lichtempfindlichen Materials.

15. Verwendung einer N-Aryl-α-aminosäure der Formel (I') nach Anspruch 2 als Photoinitiator.

## Revendications

1. N-aryl-α-amino-acide de formule 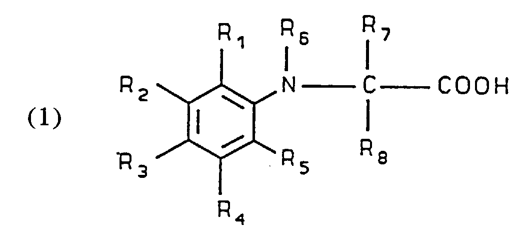 dans laquelle R₁, R₂, R₃, R₄ et R₅ représentent indépendemment l'un de l'autre un atome d'hydrogène ou d'halogène, un groupe alkyle en C₁₋₄, cyano, alcoxycarbonyle en C₂₋₁₀, CONH₂ ou alkylsulfonyle en C₁₋₄, et ledit groupe alkyle peut porter un substituant cyano, et au moins un des résidus R₁ à R₅ représente un groupe alkylsulfonyle en C₁₋₄ ; R₆ représente un atome d'hydrogène, un groupe alkyle en C₁₋₁₂, cycloalkyle, hydroxyalkyle en C₁₋₁₂, alcoxyalkyle en C₂₋₁₂, aminoalkyle en C₁₋₁₂ ou aryle ; et R₇ et R₈ représentent indépendamment l'un de l'autre un atome d'hydrogène ou un groupe alkyle en C₁₋₈.

2. Composition de photoamorçage (A) comprenant un N-aryl-α-aminoacide de formule 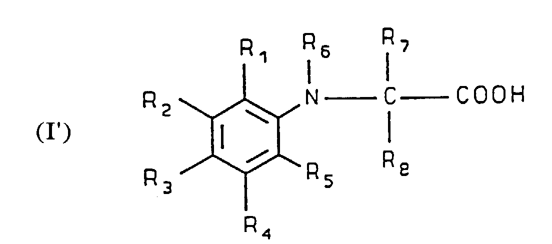 dans laquelle R₁, R₂, R₃, R₄ et R₅ représentent indépendemment l'un de l'autre un atome d'hydrogène ou d'halogène, un groupe alkyle en C₁₋₄, cyano, alcoxycarbonyle en C₂₋₁₀, CONH₂ ou alkylsulfonyle en C₁₋₄, ledit groupe alkyle pouvant porter un substituant cyano, et au moins un des résidus R₁ à R₅ représente un groupe alcoxycarbonyle en C₂₋₁₀, CONH₂ ou alkylsulfonyle en C₁₋₄ ; R₆ représente un atome d'hydrogène, un groupe alkyle en C₁₋₁₂, cycloalkyle, hydroxyalkyle en C₁₋₁₂, alcoxyalkyle en C₂₋₁₂, aminoalkyle en C₁₋₁₂ ou aryle ; et R₇ et R₈ représentent indépendamment l'un de l'autre un atome d'hydrogène ou un groupe alkyle en C₁₋₈, et au moins un élément choisi dans le groupe formé par un composé de type coumarine à triple substitution de formule 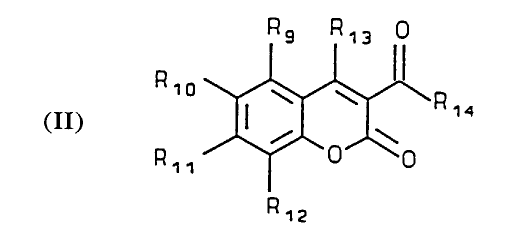 dans laquelle R₉, R₁₀, R₁₁, R₁₂ et R₁₃ représentent indépendamment les uns des autres un atome d'hydrogène, un groupe amino portant un substituant alkyle en C₁₋₅, un groupe amino portant deux substituants alkyle en C₁₋₅, un groupe alcoxy en C₁₋₅, acyloxy, aryle, un atome d'halogène, ou un groupe thioalkyle en C₁₋₅ ; et R₁₄ représente un groupe phényle non substitué, un groupe biphényle, naphtyle, thiényle, benzofuryle, furyle, pyridyle, coumarinyle, amino, amino portant un ou plusieurs substituants alkyle en C₁₋₅, un groupe cyano, alcoxy en C₁₋₅, alkyle en C₁₋₅, un atome d'halogène, un groupe halogénoalkyle, formyle, alcoxycarbonyle en C₁₋₅, acyloxy en C₁₋₅, phényle portant un substituant acyloxy en C₁₋₅, un groupe cyano, alcoxy ou acyle en C₁₋₅, lesdits groupes biphényle, naphtyle, thiényle, benzofuryle, furyle, pyridyle ou coumarinyle pouvant être substitués par un groupe acyloxy en C₁₋₅ ou un groupe acyle en C₁₋₅, et un composé de type azabenzalcyclohexanone de formule 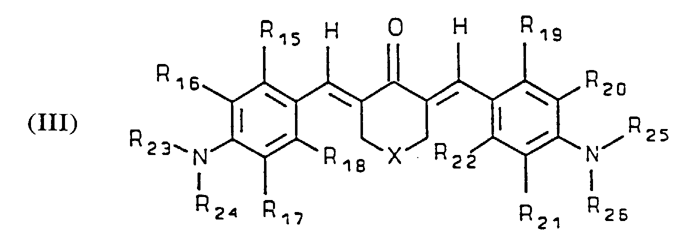 dans laquelle R₁₅, R₁₆, R₁₇, R₁₈, R₁₉, R₂₀, R₂₁ et R₂₂ représentent indépendamment chacun un atome d'hydrogène, un atome de chlore ou de brome, un groupe alkyle en C₁₋₁₂, aryle ou alcoxy en C₁₋₁₂; et R₂₃, R₂₄, R₂₅ et R₂₆ représentent indépendemment l'un de l'autre un groupe alkyle en C₁₋₆ ; X représente un groupe imino pouvant porter un substituant alkyle en C₁₋₁₂, un groupe aralkyle en C₇₋₂₀, aryle, acyle en C₂₋₁₂, arylcarbonyle en C₇₋₂₀, alcoxycarbonyle en C₂₋₁₂ ou un groupe aryloxycarbonyle en C₇₋₂₀.

3. Composition photosensible comprenant un composé photopolymérisable par réaction d'addition ayant un point d'ébullition supérieur ou égal 100 °C à pression atmosphérique, et une composition de photoamorçage (A) selon la revendication 2.

4. Composition photosensible selon la revendication 3, comprenant en outre un ou plusieurs polymères organiques ayant une masse molaire élevée.

5. Matériau photosensible comprenant
(a) un poly(amido-acide),
(b) un composé comportant une ou plusieurs doubles liaisons carbone-carbone dimérisables ou polymérisables par rayonnement actinique et un ou plusieurs groupes amino, ou un sel quaternaire d'un tel composé, et
(c) une composition de photoamorçage (A) selon la revendication 2.

6. Matériau photosensible selon la revendication 5, comprenant en outre un ou plusieurs composés de type bis-azoture.

7. Utilisation d'un matériau photosensible selon la revendication 5 pour former un motif.

8. Composition de photoamorçage (B) comprenant un N-aryl-α-amino-acide de formule 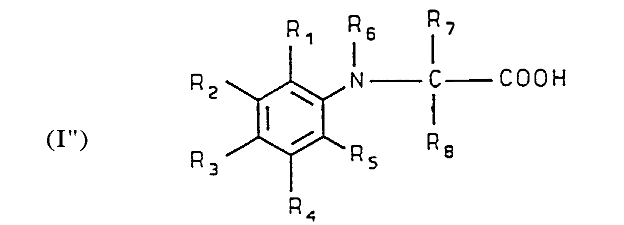 dans laquelle R₁, R₂, R₃, R₄ et R₅ représentent indépendemment l'un de l'autre un atome d'hydrogène, un groupe alkyle en C₁₋₄, cyano, alcoxycarbonyle en C₂₋₁₀, CONH₂ ou alkylsulfonyle en C₁₋₄, et ledit groupe alkyle peut porter un substituant cyano, avec la réserve que les résidus R₁ à R₅ ne représentent pas tous des atomes d'hydrogène; R₆ représente un atome d'hydrogène, un groupe alkyle en C₁₋₁₂, cycloalkyle, hydroxyalkyle en C₁₋₁₂, alcoxyalkyle en C₂₋₁₂, aminoalkyle en C₁₋₁₂ ou aryle ; et R₇ et R₈ représentent indépendamment l'un de l'autre un atome d'hydrogène ou un groupe alkyle en C₁₋₈, et un composé de type coumarine à triple substitution de formule 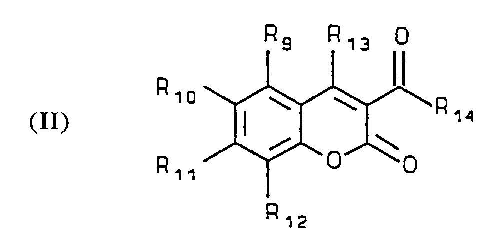 dans laquelle R₉, R₁₀, R₁₁, R₁₂ et R₁₃ représentent indépendamment les uns des autres un atome d'hydrogène, un groupe amino portant un substituant alkyle en C₁₋₅, un groupe amino portant deux substituants alkyle en C₁₋₅, un groupe alcoxy en C₁₋₅, acyloxy, aryle, un atome d'halogène, ou un groupe thioalkyle en C₁₋₅; et R₁₄ représente un groupe phényle non substitué, un groupe biphényle, naphtyle, thiényle, benzofuryle, furyle, pyridyle, coumarinyle, amino, amino portant un ou plusieurs substituants alkyle en C₁₋₅, un groupe cyano, alcoxy en C₁₋₅, alkyle en C₁₋₅, un atome d'halogène, un groupe halogénoalkyle, formyle, alcoxycarbonyle en C₁₋₅, acyloxy en C₁₋₅, phényle portant un substituant acyloxy en C₁₋₅, un groupe cyano, un groupe alcoxy ou acyle en C₁₋₅, lesdits groupes biphényle, naphtyle, thiényle, benzofuryle, furyle, pyridyle ou coumarinyle pouvant être substitués par un groupe acyloxy en C₁₋₅ ou un groupe acyle en C₁₋₅, et un composé de type titanocène de formule 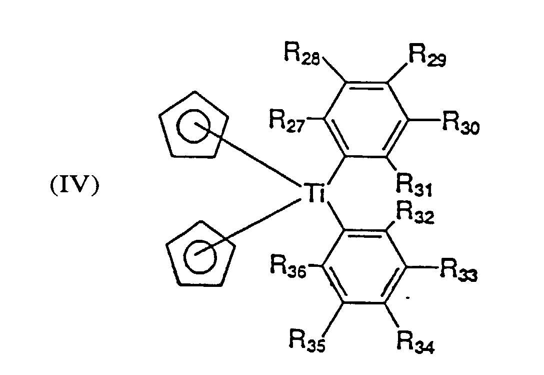 dans laquelle les restes R₂₇ à R₃₆ représentent indépendamment les uns des autres chacun un atome d'hydrogène ou d'halogène, un groupe alcoxy en C₁₋₂₀, ou un noyau hétérocyclique, ledit noyau hétérocyclique étant lié à un cycle benzénique soit directement soit par l'intermédiaire d'un groupe alkylène, et pouvant porter un ou plusieurs substituants alkyle, amino, alkylamino et alcoxy.

9. Composition photosensible comprenant un composé photopolymérisable par réaction d'addition, lequel composé a un point d'ébullition supérieur ou égal à 100 °C sous pression atmosphérique, et une composition de photoamorçage (B) selon la revendication 8.

10. Composition photosensible selon la revendication 9, comprenant en outre un ou plusieurs polymères organiques ayant une masse molaire élevée.

11. Matériau photosensible comprenant
(a) un poly(amido-acide),
(b) un composé comportant une ou plusieurs doubles liaisons carbone-carbone dimérisables ou polymérisables par rayonnement actinique, et un ou plusieurs groupes amino, ou un sel quaternaire d'un tel composé, et
(c) une composition de photoamorçage (B) selon la revendication 8.

12. Matériau photosensible selon la revendication 11 comprenant en outre un ou plusieurs composés de type bis-azoture.

13. Utilisation d'un matériau photosensible selon la revendication 11 pour former des motifs.

14. Procédé de formation de motifs comprenant les étapes consistant à
- déposer sur un substrat un matériau photosensible selon la revendication 5 ou 11,
- à sécher le matériau photosensible,
- à exposer le matériau photosensible à la lumière, et
- à développer le matériau photosensible.

15. Utilisation d'un N-aryl-α-aminoacide de formule (I') défini dans la revendication 2 en tant que photoamorceur.
